(19) Europäisches Patentamt / European Patent Office / Office européen des brevets

(11) **EP 3 828 920 A1**

(12) **DEMANDE DE BREVET EUROPEEN**

(43) Date de publication:
**02.06.2021   Bulletin 2021/22**

(51) Int Cl.:
**H01L 21/66** (2006.01)     **G01R 31/26** (2020.01)

(21) Numéro de dépôt: **20204097.8**

(22) Date de dépôt: **27.10.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **26.11.2019   FR 1913213**

(71) Demandeur: **Commissariat à l'Energie Atomique et aux Energies Alternatives**
**75015 Paris (FR)**

(72) Inventeurs:
• **VIEY, Abygael**
  **38054 GRENOBLE CEDEX 9 (FR)**
• **JAUD, Marie-Anne**
  **38054 GRENOBLE CEDEX 9 (FR)**
• **VANDENDAELE, William**
  **38054 GRENOBLE CEDEX 9 (FR)**

(74) Mandataire: **Cabinet Beaumont**
**4, Place Robert Schuman**
**B.P. 1529**
**38025 Grenoble Cedex 1 (FR)**

(54) **PROCÉDÉ D'ÉVALUATION D'UNE CONCENTRATION**

(57)     La présente description concerne un procédé d'évaluation d'une concentration de carbone en site azote, dans une première couche épitaxiée en nitrure de gallium dopé au carbone d'un composant électronique, comprenant des étapes consistant à :

estimer une capacité électrique d'un empilement intercalé entre la première couche et une première électrode du composant ;

chauffer le composant ;

mesurer un décalage d'une tension de seuil du composant ; et

en déduire une concentration surfacique de carbone en site azote dans la première couche.

**Fig. 4**

**Description**

Domaine technique

La présente description concerne de façon générale les dispositifs électroniques et, plus particulièrement, les composants électroniques de puissance à base de nitrure de gallium (GaN).

Technique antérieure

Le nitrure de gallium (GaN) entre actuellement dans la composition de nombreux composants électroniques, par exemple des transistors à haute mobilité électronique (High-Electron-Mobility Transistor - HEMT). Des transistors HEMT comportant au moins une couche cristalline en nitrure de gallium permettent notamment de commuter des courants électriques importants, par exemple de l'ordre de plusieurs dizaines d'ampères, sous des tensions de polarisation élevées, par exemple de l'ordre de plusieurs centaines de volts. Ces transistors sont, en outre, compatibles avec des fréquences de fonctionnement élevées, typiquement de l'ordre du mégahertz.

Des impuretés sont fréquemment introduites de façon volontaire dans la couche de nitrure de gallium des transistors à base de nitrure de gallium. Ces impuretés, par exemple des atomes de carbone, contribuent notamment à obtenir des transistors présentant une tenue en tension améliorée. Toutefois, une trop forte concentration en carbone dans la couche de nitrure de gallium peut réduire la durée de vie des transistors.

De manière générale, on essaie, lors de la fabrication de composants à base de nitrure de gallium, d'obtenir une concentration en carbone donnée, permettant par exemple d'atteindre un compromis optimal entre tenue en tension et durée de vie des composants. Il serait souhaitable de pouvoir évaluer, après fabrication, la concentration en carbone dans la couche de nitrure de gallium de tels composants. Cela permettrait notamment de mieux contrôler la fabrication de composants à base de nitrure de gallium.

Résumé de l'invention

Il existe un besoin d'évaluer la concentration en carbone dans la couche de nitrure de gallium d'un composant électronique.

Un mode de réalisation pallie tout ou partie des inconvénients des procédés connus d'évaluation de la concentration en carbone dans la couche de nitrure de gallium d'un composant électronique.

Un mode de réalisation prévoit un procédé d'évaluation d'une concentration de carbone en site azote, dans une première couche épitaxiée en nitrure de gallium dopé au carbone d'un composant électronique, comprenant des étapes consistant à :

estimer une capacité électrique d'un empilement intercalé entre la première couche et une première électrode du composant ;
chauffer le composant ;
mesurer un décalage d'une tension de seuil du composant ; et
en déduire une concentration surfacique de carbone en site azote dans la première couche.

Selon un mode de réalisation, ledit procédé comprend en outre une étape consistant à calculer, à partir de la concentration surfacique et d'une épaisseur partielle de la première couche, une concentration volumique de carbone en site azote dans la première couche.

Selon un mode de réalisation, le chauffage du composant est effectué à une température comprise entre cent et deux cent cinquante degrés Celsius, de préférence entre cent cinquante et deux cent cinquante degrés Celsius.

Selon un mode de réalisation, l'empilement forme, avec la première électrode, une structure de type MOS comprenant :

une deuxième couche en nitrure de gallium, située sur la première couche ; et
une troisième couche en alumine, pénétrant à l'intérieur de la deuxième couche,
la première électrode étant située sur et en contact avec la troisième couche.

Selon un mode de réalisation, la capacité est estimée en fonction d'épaisseurs et de permittivités diélectriques respectives de la deuxième couche et de la troisième couche.

Selon un mode de réalisation, la première couche est située sur un substrat, de préférence une plaquette de silicium orienté {111}.

Selon un mode de réalisation, le décalage de la tension de seuil du composant est déterminé à l'issue d'une étape d'application, entre la première électrode et une deuxième électrode du composant, d'une tension de polarisation négative.

Selon un mode de réalisation, la tension de polarisation est inférieure à -1 V, de préférence environ égale à -5 V.

Selon un mode de réalisation, l'étape d'application de la tension de polarisation dure entre une et dix mille secondes, de préférence entre cent et dix mille secondes.

Selon un mode de réalisation, l'étape d'application de la tension de polarisation est interrompue, pendant dix à cent microsecondes, à plusieurs reprises pour évaluer la tension de seuil du composant.

Selon un mode de réalisation, la tension de seuil du composant est évaluée à partir d'une mesure de variation de capacité, entre la première électrode et la deuxième électrode, en fonction d'une variation de potentiel appliqué sur la première électrode.

Selon un mode de réalisation, la tension de seuil du composant est évaluée à partir d'une mesure de variation d'un courant électrique traversant le composant, en fonction d'une variation de potentiel appliqué sur la première électrode.

Selon un mode de réalisation, le composant est un transistor, de préférence un transistor à haute mobilité électronique, la première électrode étant une électrode de grille et la deuxième électrode étant une électrode connectée au substrat.

Selon un mode de réalisation, le composant est un condensateur MOS.

Selon un mode de réalisation, des paramètres d'épitaxie de la première couche sont adaptés en fonction de l'évaluation de la concentration de carbone en site azote.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

La figure 1 est une vue en perspective et en coupe, schématique et partielle, d'un mode de réalisation d'un transistor à effet de champ ;

La figure 2 est une vue en coupe, schématique et partielle, d'une portion du transistor de la figure 1 illustrant un mode de fonctionnement ;

La figure 3 est une vue en coupe, schématique et partielle, de la portion de la figure 2 du transistor de la figure 1 illustrant un autre mode de fonctionnement ;

La figure 4 est un logigramme d'enchaînement d'étapes d'un mode de mise en œuvre d'un procédé d'évaluation d'une concentration de carbone en site azote dans une couche de nitrure de gallium ;

La figure 5 est un circuit équivalent à la portion de la figure 2 du transistor de la figure 1 ;

La figure 6 est une vue en coupe simplifiée, schématique et partielle, du transistor de la figure 1 ;

La figure 7 est un chronogramme d'évolution d'un potentiel de grille ;

La figure 8 est un graphique de variation d'un courant de drain en fonction d'un potentiel de grille ;

La figure 9 est un graphique de variation d'une capacité en fonction d'un potentiel de grille ;

La figure 10 est un graphique d'évolution, en fonction du temps et pour différentes températures, d'un décalage d'une tension de seuil d'un composant électronique ;

La figure 11 est un graphique d'évolution, en fonction du temps et pour différentes températures, d'un décalage d'une tension de seuil d'un autre composant électronique ;

La figure 12 est une vue en coupe simplifiée, schématique et partielle, d'un exemple de condensateur ;

La figure 13 est une vue en coupe simplifiée, schématique et partielle, de la portion de la figure 2 du transistor de la figure 1 dans encore un autre mode de fonctionnement ;

La figure 14 est une vue en coupe simplifiée, schématique et partielle, de la portion de la figure 2 du transistor de la figure 1 dans encore un autre mode de fonctionnement ;

La figure 15 est une vue schématique et partielle d'un transistor dans un mode de fonctionnement ;

La figure 16 est une vue schématique et partielle d'un autre transistor dans un autre mode de fonctionnement ;

La figure 17 est un graphique d'évolution, en fonction du temps, d'un décalage d'une tension de seuil de composants électroniques ;

La figure 18 est un graphique d'Arrhenius associé à une première constante de temps ;

La figure 19 est un graphique d'Arrhenius associé à une deuxième constante de temps ;

La figure 20 est un graphique de variation, en fonction d'une profondeur, d'une concentration en espèces chimiques ;

La figure 21 est une vue en coupe, schématique et partielle, d'un transistor normalement bloqué ;

La figure 22 est une vue en coupe, schématique et partielle, d'un transistor normalement passant ;

La figure 23 est un graphique d'évolution, en fonction du temps, d'un décalage d'une tension de seuil des transistors des figures 21 et 22 ;

La figure 24 est une cartographie de pièges ionisés à l'intérieur de la portion de la figure 2 du transistor de la figure 1 dans un mode de fonctionnement ;

La figure 25 est une cartographie de pièges ionisés à l'intérieur de la portion de la figure 2 du transistor de la figure 1 dans un autre mode de fonctionnement ;

La figure 26 est un graphique de variation, en fonction d'une profondeur, d'une énergie de bande de conduction ; et

La figure 27 est un graphique d'évolution, en fonction du temps, d'une énergie de bande de conduction.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les procédés de fabrication des composants électroniques à base de nitrure de gallium ne sont pas détaillés, l'invention étant compatible avec les procédés usuels de fabrication de composants électroniques à base de nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

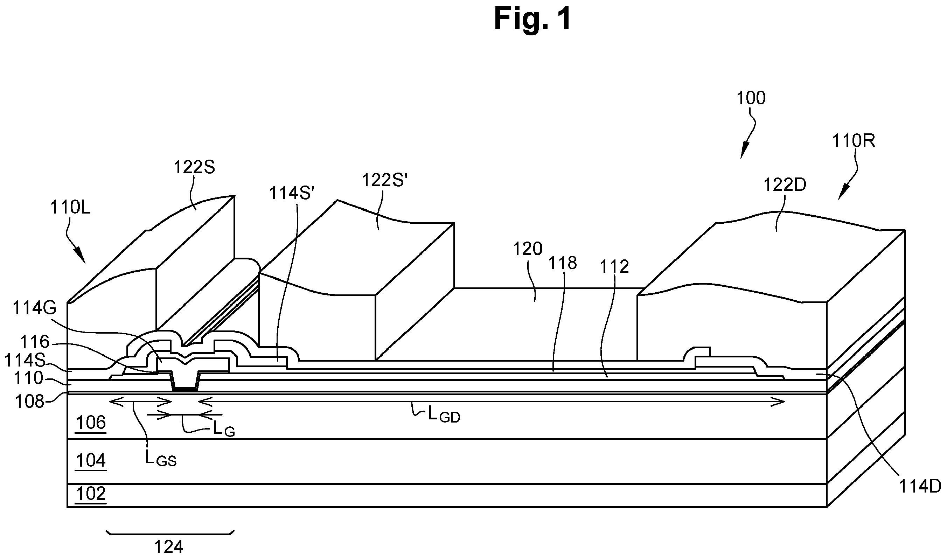

La figure 1 est une vue en perspective et en coupe, schématique et partielle, d'un mode de réalisation d'un transistor 100 à effet de champ.

Selon ce mode de réalisation, le transistor 100 comporte un substrat 102. Le substrat 102 est, par exemple, une plaquette (wafer) de deux cents millimètres (huit pouces) de diamètre, majoritairement constituée de silicium (Si) cristallin, et dont une surface (la surface supérieure du substrat 102, dans l'orientation de la figure 1) est orientée {111}.

Comme illustré en figure 1, une couche 104 est située sur et en contact avec la surface supérieure du substrat 102. La couche 104 est, de préférence, une couche « pleine plaque », autrement dit une couche recouvrant intégralement la surface supérieure du substrat 102. Dans le mode de réalisation du transistor 100, la couche 104 est, de préférence, une couche dite de transition possédant une composition différente de celle du substrat 102.

Une autre couche 106 du transistor 100 est située sur et en contact avec la couche 104. La couche 106 est, par exemple, réalisée par croissance épitaxiale à partir d'une surface de la couche 104 de transition (la surface supérieure de la couche 104, dans l'orientation de la figure 1). La couche 104 permet notamment une adaptation progressive de paramètre de maille, entraînant par exemple une relaxation des contraintes de réseau, entre le substrat 102 et la couche 106.

Selon un mode de réalisation, la couche 106 est en nitrure de gallium (GaN) dopé. Plus précisément, la couche 106 présente une structure cristalline comportant des mailles de nitrure de gallium dans lesquelles des impuretés dopantes, de préférence des atomes de carbone (C), sont volontairement introduites. Cela signifie, en d'autres termes, que la couche 106 forme un réseau cristallin de nitrure de gallium et que, dans certaines mailles de ce réseau, un ou plusieurs atomes sont substitués chacun par un atome de carbone.

Selon un mode de réalisation préféré, les atomes de carbone introduits pendant l'épitaxie de la couche 106 se substituent principalement à des atomes d'azote du réseau cristallin de nitrure de gallium. On dit alors que ces atomes de carbone occupent des sites azote de la structure cristalline en nitrure de gallium de la couche 106 du transistor 100 ou, plus simplement, que ces atomes de carbone sont « en site azote ».

Les atomes de carbone en site azote dans la couche 106 en nitrure de gallium se comportent comme des accepteurs. En d'autres termes, la présence d'atomes de carbone en site azote dans la couche 106 en nitrure de gallium conduit à un dopage de type p de la couche 106. Cela permet, en particulier, d'obtenir un transistor 100 présentant une meilleure tenue en tension qu'un transistor équivalent dont la couche 106 serait dépourvue d'atomes de carbone en site azote.

Dans la suite de la description, on désigne par « GaN:C » la composition d'une couche principalement constituée de nitrure de gallium et comportant des atomes de carbone en site azote, par exemple la couche 106 du transistor 100.

Comme illustré en figure 1, le transistor 100 comporte encore une autre couche 108. La couche 108 est située sur et en contact avec la couche 106. La couche 108 agit, de préférence, comme une couche barrière (barrier layer). Dans le cas du transistor 100, la couche 108 permet d'ajuster une valeur de tension de seuil, notée $V_{TH}$, du transistor 100.

Le transistor 100 comporte encore une autre couche 110. La couche 110 est située sur et en contact avec la couche 108. La couche 110 du transistor 100 est principalement constituée de nitrure de gallium. Selon un mode de réalisation, la couche 110 comporte des impuretés dopantes. Les impuretés présentes dans la couche 110 peuvent être introduites de façon involontaire pendant et/ou après une ou plusieurs étapes de réalisation de la couche 110. Le cas échéant, la couche 110 est dite involontairement dopée (unintentionally doped).

Dans la suite de la description, on désigne par « GaN:UID » la composition d'une couche principalement constituée de nitrure de gallium involontairement dopé, par exemple la couche 110 du transistor 100.

La couche 110 est partiellement recouverte par encore une autre couche 112. Selon un mode de réalisation, la couche 112 possède une structure multicouche. En variante, la couche 112 possède une structure monocouche.

Dans l'orientation de la figure 1, la couche 112 est située sur et en contact avec une partie de la surface supérieure de la couche 110. En particulier, toujours dans l'orientation de la figure 1 :

une partie 110L de la couche 110, située du côté gauche du transistor 100, n'est pas recouverte par la couche 112 ; et
une autre partie 110R de la couche 110, située du côté droit du transistor 100, n'est pas recouverte par la couche 112.

Comme illustré en figure 1, une électrode de source 114S du transistor 100 est située sur et en contact avec la partie 110L de la couche 110 non recouverte par la couche 112. De façon analogue, une électrode de drain 114D du transistor 100 est située sur et en contact avec la partie 110R de la couche 110 non recouverte par la couche 112. L'électrode de source 114S et l'électrode de drain 114D sont, par exemple, réalisées à partir d'une même couche.

En outre, une électrode de grille 114G du transistor 100 est située entre l'électrode de source 114S et l'électrode de drain 114D. L'électrode de grille 114G s'étend verticalement depuis la surface supérieure de la couche 112 vers la partie inférieure du transistor 100. Plus précisément, l'électrode de grille 114G traverse la couche 112 sur toute son épaisseur et pénètre à l'intérieur de la couche 110 sans traverser la couche 110. En outre, l'électrode de grille 114G du transistor 100 s'étend latéralement sur la couche 112. L'électrode de grille 114G présente, vue en coupe en figure 1, une section en forme de « T ».

Selon un mode de réalisation, l'électrode de grille 114G est constituée d'au moins un métal et/ou d'au moins un alliage métallique.

Dans le transistor 100, encore une autre couche 116 est intercalée entre l'électrode de grille 114G et les couches 110 et 112. La couche 116 du transistor 100 est une couche d'oxyde de grille, destinée à isoler électriquement l'électrode de grille 114G par rapport aux couches 110 et 112. La couche 116 est, de préférence, majoritairement constituée d'alumine (Al$_2$O$_3$). La couche 116 possède une épaisseur comprise entre 20 nm et 40 nm, de préférence égale à 30 nm.

Comme illustré en figure 1, encore une autre couche 118 du transistor 100 recouvre intégralement la partie supérieure du « T », formé par l'électrode de grille 114G, et des faces latérales de la couche 116 d'oxyde de grille. La couche 118 est située sur et en contact avec la face supérieure de la couche 112. Dans l'orientation de la figure 1, la couche 118 se prolonge latéralement vers la gauche, jusqu'à l'électrode de source 114S, et vers la droite, jusqu'à l'électrode de drain 114D.

L'électrode de source 114S est sur et en contact avec une partie de la couche 112 et une partie de la couche 118, ces parties étant toutes deux situées du côté gauche du « T » formé par l'électrode de grille 114G. Dans l'orientation de la figure 1, l'électrode de drain 114D est sur et en contact avec une partie de la couche 112 et une partie de la couche 118, ces parties étant toutes deux situées du côté droit du transistor 100.

Selon un mode de réalisation, une autre électrode de source 114S' est située sur et en contact avec une partie de la couche 118 située du côté droit du « T » formé par l'électrode de grille 114G.

Dans le transistor 100, encore une autre couche 120 est située sur et en contact avec une partie de la couche 118 située entre l'électrode de source 114S' et l'électrode de drain 114D. Comme illustré en figure 1, la couche 120 se prolonge latéralement :

vers la gauche du transistor 100, sur l'électrode de source 114S', sur une partie de couche 118 recouvrant l'électrode de grille 114G et sur une partie droite de l'électrode de source 114S, jusqu'à l'aplomb de l'extrémité gauche de la couche 118 ; et
vers la droite du transistor 100, sur une partie gauche de l'électrode de drain 114D.

Les couches 118 et 120 sont, de préférence, à base de matériaux diélectriques. À titre d'exemple, la couche 120 peut être constituée d'orthosilicate de tétraéthyle (TetraEthyl OrthoSilicate - TEOS).

Le transistor 100 comporte, en outre :

un plot ou borne de source 122S, s'étendant sur et en contact avec une partie gauche de l'électrode de source 114S et une partie gauche de la couche 120 ;
un autre plot ou borne de source 122S', s'étendant sur et en contact avec une autre partie de la couche 120 située du côté droit de l'électrode de grille 114G ; et
un plot ou borne de drain 122D, situé sur et en contact avec une partie droite de la couche 120 et une partie droite de l'électrode de drain 114D.

Comme illustré en figure 1, le plot de source 122S et le plot de drain 122D sont connectés, respectivement, à l'électrode de source 114S et à l'électrode de drain 114D. Lorsque le plot de source 122S est porté à un potentiel noté $V_S$, cela revient à porter l'électrode de source 114S au potentiel $V_S$. De façon analogue, lorsque le plot de drain 122D est porté à un potentiel noté $V_D$, cela revient à porter l'électrode de drain 114D au potentiel $V_D$.

En outre, bien que cela ne soit pas représenté en figure 1, l'électrode de grille 114G peut être reliée, de préférence connectée, à un plot ou borne de grille. Le cas échéant, lorsque ce plot de grille est porté à un potentiel noté $V_G$, cela revient à porter l'électrode de grille 114G au potentiel $V_G$.

Selon un mode de réalisation, l'électrode de source 114S est connectée au substrat 102. Le potentiel $V_S$ auquel est portée l'électrode de source 114S est alors équivalent à un potentiel appliqué sur le substrat 102 du transistor 100, généralement la masse.

Comme illustré en figure 1, on note :

> $L_{GS}$ une distance séparant une partie inférieure de l'électrode de source 114S de la partie verticale du « T » formé par l'électrode de grille 114G ;
> $L_{GD}$ une distance séparant la partie verticale du « T » formé par l'électrode de grille 114G d'une partie inférieure de l'électrode de drain 114D ; et
> $L_G$ la longueur de la partie verticale du « T » formé par l'électrode de grille 114G.

En d'autres termes, dans l'orientation de la figure 1, la distance $L_{GS}$ correspond à une dimension latérale d'une portion de la couche 112 située du côté gauche de l'électrode de grille 114G. La distance $L_{GD}$ correspond à une dimension latérale d'une portion de la couche 112 située du côté droit de l'électrode de grille 114G. De manière plus générale, les distances $L_{GS}$, $L_{GD}$, et $L_G$ correspondent respectivement à la distance grille-source, à la distance grille-drain et à la longueur de grille du transistor 100.

Selon le mode de réalisation exposé en relation avec la figure 1, le transistor 100 est un transistor à effet de champ, plus particulièrement un transistor à effet de champ à structure métal-oxyde-semiconducteur (Metal Oxide Semiconductor - MOS) ou métal-isolant-semiconducteur (Metal Insulator Semiconductor - MIS). Le transistor 100 est, de préférence, un transistor à haute mobilité électronique (High Electron Mobility Transistor - HEMT). Le transistor 100 est dit « normalement bloqué » (normally-off). En d'autres termes, le transistor 100 ne laisse passer aucun courant, ou un courant électrique négligeable, entre son électrode de source 114S et son électrode de drain 114D lorsque son électrode de grille 114G est portée à un potentiel électrique sensiblement nul.

Le transistor 100 de la figure 1 est adapté à commuter des courants électriques d'une intensité de l'ordre de 30 A sous une tension de polarisation l'ordre de 600 V entre son électrode de source 114S et son électrode de drain 114D (donc entre son plot de source 122S et son plot de drain 122D). Le transistor 100 peut en particulier être utilisé pour des applications de commutation de signaux de puissance à des fréquences de l'ordre du mégahertz (MHz).

Dans la suite de la description, on s'intéresse plus particulièrement à une portion 124 du transistor 100. La portion 124 est approximativement centrée sur l'électrode de grille 114G et inclut des zones du transistor 100 situées au voisinage de l'électrode de grille 114G.

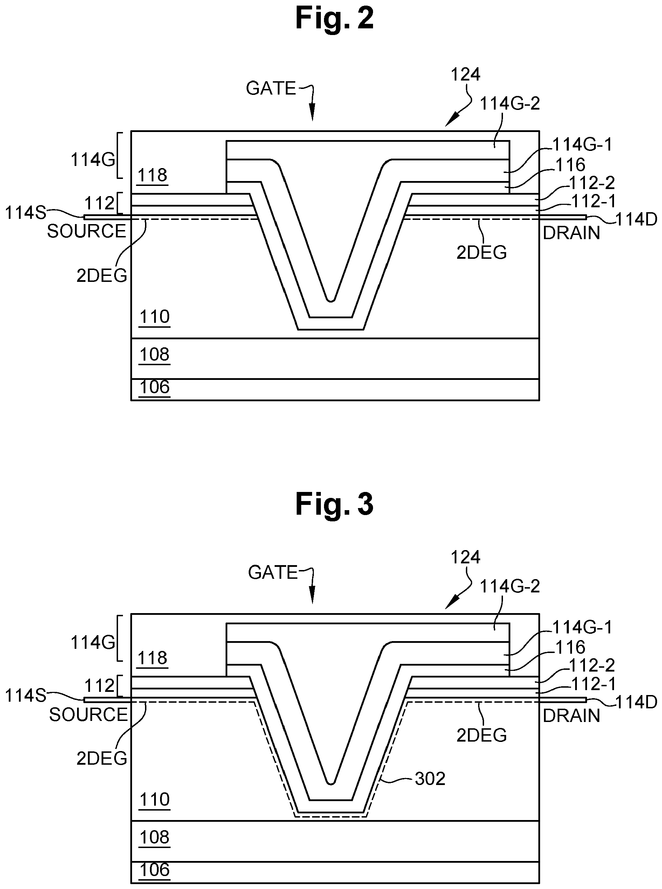

La figure 2 est une vue en coupe, schématique et partielle, de la portion 124 du transistor 100 de la figure 1 illustrant un mode de fonctionnement où le transistor 100 est bloqué.

En d'autres termes, dans le mode de fonctionnement de la figure 2, le transistor 100 ne laisse passer aucun courant électrique, ou un courant d'intensité négligeable, entre son électrode de source 114S (SOURCE) et son électrode de drain 114D (DRAIN). Le mode de fonctionnement illustré en figure 2 correspond, par exemple, à une situation dans laquelle on applique, entre l'électrode de grille 114G (GATE) et l'électrode de source 114S du transistor 100, une tension, notée $V_{GS}$, inférieure à la tension de seuil $V_{TH}$ du transistor 100. Le transistor 100 étant normalement bloqué, la tension de seuil $V_{TH}$ correspond à une valeur de tension limite au-dessus de laquelle le transistor 100 devient passant.

L'électrode de source 114S du transistor 100 est, par exemple, mise à la masse, c'est-à-dire portée à un potentiel sensiblement nul. La tension $V_{GS}$ est alors environ égale au potentiel $V_G$ appliqué sur l'électrode de grille 114G du transistor 100.

Comme illustré en figure 2, la couche 112 présente une structure multicouche comprenant une sous-couche 112-1, située sur et en contact avec la couche 110 de GaN:UID, et une autre sous-couche 112-2, située sur et en contact avec la sous-couche 112-1. De façon analogue, l'électrode de grille 114G présente une structure multicouche comprenant une sous-couche 114G-1, située sur et en contact avec la couche 116 d'oxyde de grille, et une autre sous-couche 114G-2, située sur et en contact avec la sous-couche 114G-1.

Selon un mode de réalisation :

> la sous-couche 112-1 de la couche 112 est constituée de nitrure d'aluminium-gallium (AlGaN) ;
> la sous-couche 112-2 de la couche 112 est une couche de passivation pouvant présenter une structure multicouche ;
> la sous-couche 114G-1 de l'électrode de grille 114G est constituée d'au moins un métal et/ou d'au moins un alliage métallique ; et
> la sous-couche 114G-2 de l'électrode de grille 114G est constituée d'au moins un métal et/ou d'au moins un alliage métallique.

La couche d'oxyde de grille 116 présente, vue en coupe en figure 2, une forme de « V » à l'intérieur de laquelle s'insère l'électrode de grille 114G en forme de « T ». Deux parties horizontales de la couche 116 s'étendent latéralement sur et en contact avec la sous-couche 112-2 de la couche 112. Deux parties obliques de la couche 116 traversent la couche 112 et rejoignent une autre partie horizontale de la couche 116 formée à l'intérieur de la couche 110 de GaN:UID. On dit que la grille du transistor 100, comprenant la couche 116 d'oxyde de grille et l'électrode de grille 114G, est « encastrée » (recessed) dans la couche 110 de GaN:UID.

La grille du transistor 100 est obtenue, par exemple, en formant une cavité à l'intérieur de la couche 110 puis en déposant successivement, dans cette cavité, la couche 116 et les sous-couches 114G-1 et 114G-2 de l'électrode de grille 114G. On réalise ainsi une grille de type MOS.

La grille du transistor 100, encastrée dans la couche 110, sépare deux parties d'un gaz d'électrons bidimensionnel (2DEG). Le gaz d'électrons bidimensionnel 2DEG est symbolisé, en figure 2, par deux traits en pointillé situés de part et d'autre de l'électrode de grille 114G. Comme illustré en figure 2, le gaz d'électrons bidimensionnel 2DEG est localisé dans la couche 110 de GaN:UID, à proximité de l'interface entre la couche 110 et la sous-couche 112-1 d'AlGaN. Les électrodes de source 114S et de drain 114D (symbolisées par deux traits pleins en figure 2) sont, de préférence, connectées au gaz d'électrons bidimensionnel 2DEG.

Dans le mode de fonctionnement illustré en figure 2 où le potentiel $V_G$ appliqué sur l'électrode de grille 114G est inférieur à la tension de seuil $V_{TH}$ du transistor 100, le gaz d'électrons bidimensionnel 2DEG est interrompu au niveau de la grille. Dans ce mode de fonctionnement, il n'existe donc pas de chemin de conduction continu entre l'électrode de source 114S et l'électrode de drain 114D du transistor 100. Le transistor 100 se trouve donc dans un état non passant ou bloqué.

La figure 3 est une vue en coupe, schématique et partielle, de la portion 124 de la figure 2 du transistor 100 de la figure 1 illustrant un autre mode de fonctionnement où le transistor 100 est passant.

En d'autres termes, dans le mode de fonctionnement de la figure 3, le transistor 100 laisse passer, entre son électrode de source 114S (SOURCE) et son électrode de drain 114D (DRAIN), un courant électrique d'intensité non nulle, par exemple de l'ordre de plusieurs dizaines d'ampères. Le mode de fonctionnement illustré en figure 3 correspond, par exemple, à une situation dans laquelle le potentiel $V_G$ appliqué sur l'électrode de grille 114G (GATE) du transistor 100 excède la tension de seuil $V_{TH}$ du transistor 100.

Dans le mode de fonctionnement illustré en figure 3, les deux parties du gaz d'électrons bidimensionnel 2DEG sont reliées, au niveau de la grille du transistor 100, par un canal d'électrons 302. Dans ce mode de fonctionnement, il existe donc un chemin de conduction, constitué des deux parties du gaz d'électrons bidimensionnel 2DEG et du canal d'électrons 302, entre l'électrode de source 114S et l'électrode de drain 114D du transistor 100. Le transistor 100 se trouve donc dans un état passant.

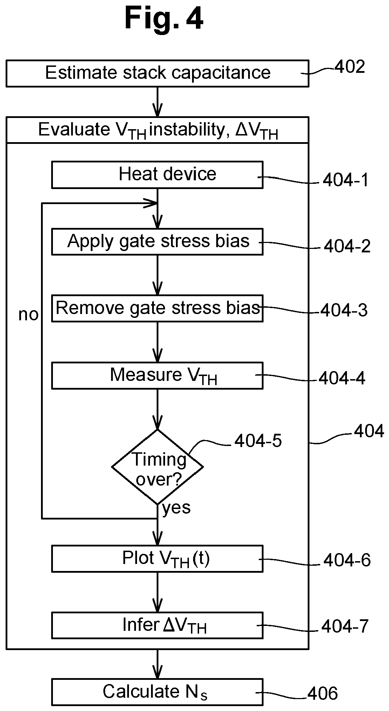

La figure 4 est un logigramme d'enchaînement d'étapes d'un mode de mise en œuvre d'un procédé d'évaluation d'une concentration de carbone en site azote dans une couche de nitrure de gallium d'un dispositif.

Le mode de mise en œuvre du procédé décrit en relation avec la figure 4 permet, par exemple, d'évaluer une concentration d'atomes de carbone en site azote dans la couche 106 de GaN:C du transistor 100 (figure 1).

Le procédé illustré en figure 4 comporte une étape (bloc 402, Estimate stack capacitance) consistant à estimer une valeur de capacité électrique, notée $C_{eq}$, d'un empilement de couches. Pour un empilement de N couches présentant des capacités respectivement notées $C_1$, $C_2$, ..., $C_N$, la capacité équivalente $C_{eq}$ des N capacités $C_1$ à $C_N$ associées en série est définie par l'équation suivante :

$$[Math\ 1]$$

$$C_{eq} = \frac{1}{\left(\sum_{k=1}^{N} \frac{1}{C_k}\right)}$$

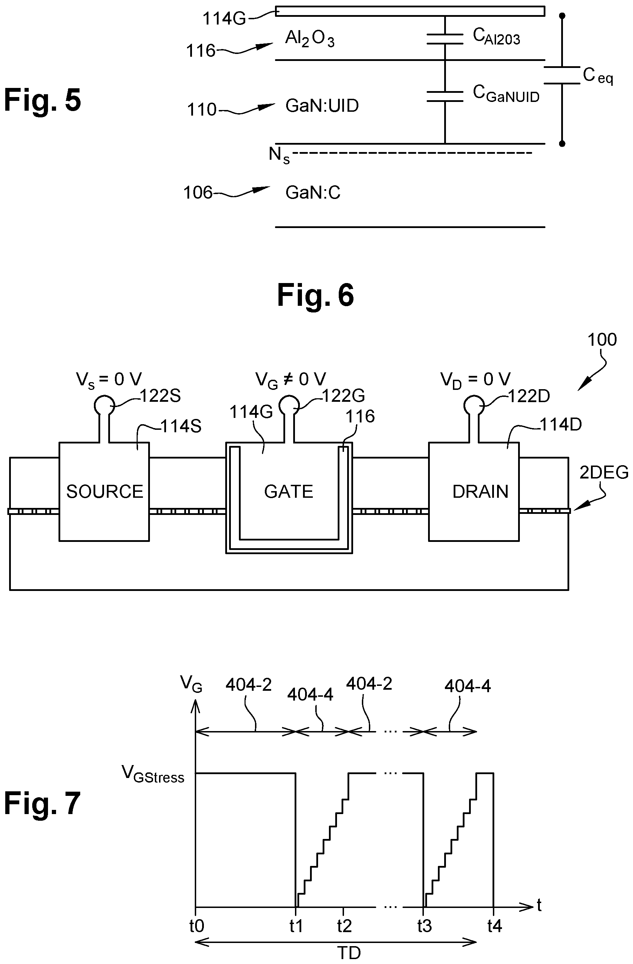

Dans le cas du transistor 100 (figure 1), la capacité équivalente $C_{eq}$ est estimée, par exemple, à partir des capacités des couches comprises entre l'électrode de grille 114G et la couche 106 de GaN: C dont on souhaite évaluer la concentration d'atomes de carbone en site azote. L'estimation de la capacité équivalente $C_{eq}$ dans le cas du transistor 100 est exposée plus en détail ci-dessous en relation avec la figure 5.

Le procédé illustré en figure 4 comporte une autre étape (bloc 404, Evaluate $V_{TH}$ instability, $\Delta V_{TH}$), postérieure à l'étape 402. L'étape 404 consiste à évaluer un décalage, noté $\Delta V_{TH}$, de la tension de seuil $V_{TH}$ du transistor 100 sous l'effet du potentiel $V_G$ appliqué sur la grille du transistor 100.

Selon un mode de mise en œuvre, l'étape 404 comporte une sous-étape (bloc 404-1, Heat device) consistant à chauffer le dispositif, dans ce cas le transistor 100. Le transistor 100 est chauffé à une température comprise entre cent degrés Celsius (100 °C) et deux cent cinquante degrés Celsius (250 °C), de préférence entre cent cinquante degrés Celsius (150 °C) et deux cent cinquante degrés Celsius (250 °C). Selon ce mode de mise en œuvre, la température à laquelle le transistor 100 est chauffé est ensuite maintenue la plus stable possible jusqu'à la fin de l'étape 404.

L'étape 404 comporte une autre sous-étape (bloc 404-2, Apply gate stress bias), postérieure à la sous-étape 404-1. La sous-étape 404-2 consiste à appliquer sur la grille du transistor 100 un potentiel $V_G$ de grille non nul, de préférence strictement négatif. Selon un mode de mise en œuvre, le potentiel de grille $V_G$ appliqué sur la grille du transistor 100 durant la sous-étape 404-2 est inférieur à -1 V, de préférence environ égal à -5 V. Dans le cas où la source du transistor 100 est mise à la masse, le potentiel $V_G$ appliqué sur la grille du transistor 100 équivaut à la tension de polarisation grille-source $V_{GS}$. Durant la sous-étape 404-2, le transistor 100 est soumis au potentiel $V_G$, ou à la tension de polarisation $V_{GS}$, pendant une durée de l'ordre du dixième de seconde (0, 1 s).

Selon un mode de mise en œuvre préféré, l'étape 404-2 est précédée par une opération (non représentée en figure 4) consistant à mesurer une valeur initiale de la tension de seuil $V_{TH}$ du transistor 100. Cette valeur initiale de la tension de seuil $V_{TH}$ sert ultérieurement de référence pour déterminer le décalage $\Delta V_{TH}$ de la tension de seuil $V_{TH}$ du transistor 100.

L'étape 404 comporte encore une autre sous-étape (bloc 404-3, Remove gate stress bias), postérieure à la sous-étape 404-2. La sous-étape 404-3 consiste à cesser temporairement d'appliquer un potentiel $V_G$ strictement négatif sur la grille du transistor 100.

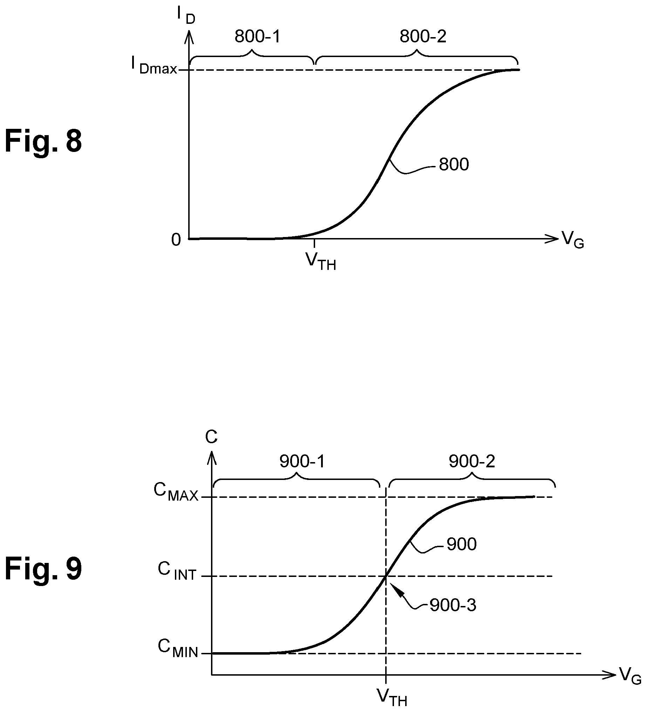

L'étape 404 comporte encore une autre sous-étape (bloc 404-4, Measure $V_{TH}$), postérieure à la sous-étape 404-3. La sous-étape 404-4 consiste à effectuer une mesure de la tension de seuil $V_{TH}$ du transistor 100. Des opérations permettant d'obtenir une mesure de la tension de seuil $V_{TH}$ sont exposées plus en détail ci-dessous en relation avec les figures 8 et 9.

Selon un mode de mise en œuvre, la mesure de la tension de seuil $V_{TH}$ est effectuée pendant une durée comprise entre dix microsecondes ($10^{-5}$ s) et cent microsecondes ($10^{-4}$ s), de préférence égale à dix microsecondes ($10^{-5}$ s).

Les sous-étapes successives 404-2, 404-3 et 404-4 sont, de préférence, répétées plusieurs fois pendant une durée totale, notée TD. La durée TD est comprise entre une seconde (1 s) et dix mille secondes ($10^4$ s), de préférence entre cent secondes (100 s) et dix mille secondes ($10^4$ s). La durée TD correspond, aux interruptions près permettant la mesure de la tension de seuil $V_{TH}$, à une durée totale d'application du potentiel $V_G$ pendant l'étape 404.

L'étape 404 comporte encore une autre sous-étape (bloc 404-5, Timing over?), postérieure à la sous-étape 404-4. La sous-étape 404-5 consiste à tester si la durée TD est écoulée ou non. Si la durée TD n'est pas encore écoulée (sortie « no » du bloc 404-5), on revient à la sous-étape 404-2 d'application du potentiel $V_G$ et on répète les opérations des sous-étapes successives 404-2, 404-3 et 404-4.

Si la durée TD est écoulée (sortie « yes » du bloc 404-5), on cesse d'appliquer le potentiel $V_G$ et de mesurer la tension de seuil $V_{TH}$. On poursuit alors l'étape 404 en passant à encore une autre sous-étape (bloc 404-6, Plot $V_{TH}$ (t)), postérieure à la sous-étape 404-5 dans le cas où la durée TD est écoulée. Selon un mode de mise en œuvre, la sous-étape 404-6 consiste à tracer une courbe d'évolution, en fonction du temps t, de la tension de seuil $V_{TH}$ à partir des différentes valeurs mesurées lors de la sous-étape 404-4.

L'étape 404 comporte encore une autre sous-étape (bloc 404-7, Infer $\Delta V_{TH}$), postérieure à la sous-étape 404-6. Selon un mode de mise en œuvre, la sous-étape 404-7 consiste à déduire, à partir de la courbe obtenue lors de la sous-étape 404-6, le décalage $\Delta V_{TH}$ de la tension de seuil $V_{TH}$ du transistor 100 sous l'effet de l'application du potentiel $V_G$ pendant la durée TD au cours de l'étape 404. Selon un mode de mise en œuvre préféré, on se base, pour déduire le décalage $\Delta V_{TH}$, sur la valeur initiale de la tension de seuil $V_{TH}$ du transistor 100 telle que mesurée préalablement à l'étape 404-2 d'application du potentiel de grille $V_G$.

Le procédé illustré en figure 4 comporte encore une autre étape (bloc 406, Calculate $N_S$), postérieure à l'étape 404. L'étape 406 consiste à calculer une concentration surfacique, notée $N_S$, de carbone en site azote dans la couche de GaN:C du dispositif étudié. La concentration surfacique $N_S$ est calculée à partir :

de la capacité équivalente $C_{eq}$, obtenue à l'issue de l'étape 402 ;
du décalage $\Delta V_{TH}$ de la tension de seuil $V_{TH}$, obtenu à l'issue de l'étape 404 ; et
de la charge élémentaire, notée q, approximativement égale à 1, 6.$10^{-19}$ C.

Plus précisément, la concentration surfacique $N_S$ est calculée en appliquant la formule suivante :

[Math 2]

$$N_S = \frac{C_{eq} \times \Delta V_{TH}}{q}$$

Selon un mode de mise en œuvre, une concentration volumique, notée $N_V$, est ensuite calculée à partir de la concentration surfacique $N_S$ et d'une épaisseur partielle, notée $t_{eff}$, de la couche 106. La concentration volumique $N_V$ est, par exemple, calculée au cours d'une étape (non représentée en figure 4) postérieure à l'étape 406. Dans la suite de la description, l'épaisseur partielle $t_{eff}$ est également appelée épaisseur efficace. L'épaisseur efficace $t_{eff}$ est, de préférence, de l'ordre de cent nanomètres.

Plus précisément, la concentration volumique $N_V$ est calculée en appliquant la formule suivante :

[Math 3]

$$N_V = \frac{N_S}{t_{eff}}$$

Dans le cas du transistor 100, la mise en œuvre du procédé exposé ci-dessus en relation avec la figure 4 permet notamment d'estimer la concentration surfacique $N_S$ de carbone en site azote dans la couche 106 (figure 1) épitaxiée en nitrure de gallium dopé au carbone. L'estimation de la concentration surfacique $N_S$ est, en particulier, valable pour une zone de la couche 106 située au voisinage de l'interface entre la couche 106 et la couche 108 (figure 1).

Un avantage du mode de mise en œuvre exposé en relation avec la figure 4 réside dans le fait que l'estimation de la concentration surfacique $N_S$ de carbone en site azote dans la couche 106 permet d'adapter des paramètres d'épitaxie de la couche 106. Lors d'étapes de développement d'un composant électronique, par exemple le transistor 100 de la figure 1, on peut faire varier des paramètres d'épitaxie de la couche 106 jusqu'à obtenir un transistor 100 présentant des performances électriques (par exemple une tenue en tension, une fréquence de commutation, une chute de tension, etc.) satisfaisantes. On évalue ensuite la concentration surfacique $N_S$ de carbone en site azote dans la couche 106 de ce transistor 100. Après avoir fabriqué d'autres transistors 100 similaires, on peut effectuer d'autres mesures de concentration surfacique $N_S$ dans les couches 106 de ces autres transistors. On contrôle ainsi, par exemple, une répétabilité d'un processus de fabrication de transistors 100.

On aurait pu penser évaluer la teneur en carbone dans la couche 106 du transistor 100 par l'une des techniques actuelles d'analyse, par exemple par spectrométrie de masse des ions secondaires (Secondary Ion Mass Spectroscopy - SIMS). Toutefois, les techniques actuelles ne permettent pas de quantifier précisément la concentration de carbone en site azote dans une couche de nitrure de gallium telle que la couche 106 du transistor 100.

La figure 5 est un circuit équivalent à la portion 124 du transistor 100 de la figure 1. La figure 5 illustre en particulier un mode de mise en œuvre, dans le cas du transistor 100, de l'étape 402 du procédé exposé en relation avec la figure 4.

En figure 5, seules la couche 106 (GaN:C) en nitrure de gallium dopé au carbone, la couche 110 (GaN:UID) en nitrure de gallium involontairement dopé et la couche 116 ($Al_2O_3$) en alumine sont représentées. À des fins de simplification, la couche 108 est ici omise de l'empilement 124. On suppose que :

la couche 110 possède une capacité notée $C_{GaNUID}$ ; et
la couche 116 possède une capacité notée $C_{Al2O3}$.

La capacité équivalente $C_{eq}$ correspond, dans cet exemple, à la capacité des couches formant un empilement séparant l'électrode de grille 114G (figure 1) de la couche 106 de GaN:C dont on souhaite évaluer la concentration surfacique $N_S$ de carbone en site azote, comme exposé en relation avec le mode de mise en œuvre de la figure 4.

Dans le cas de la figure 5 où la couche 108 est omise, la capacité équivalente $C_{eq}$ de l'empilement formé par les couches 110 et 116 est alors obtenue par la formule suivante :

[Math 4]

$$C_{eq} = \frac{1}{\dfrac{1}{C_{GaNUID}} + \dfrac{1}{C_{Al2O3}}}$$

Selon un mode de mise en œuvre, les capacités $C_{GaNUID}$ et $C_{Al2O3}$ sont estimées en fonction d'épaisseurs et de permittivités diélectriques respectives des couches 110 et 116. Les épaisseurs et les permittivités diélectriques respectives des couches 110 et 116 sont, de préférence, estimées de façon théorique. En variante, les épaisseurs et/ou les permittivités diélectriques respectives des couches 110 et 116 sont obtenues par au moins une mesure effectuée sur le transistor 100.

La figure 6 est une vue en coupe simplifiée, schématique et partielle, du transistor 100 de la figure 1. La figure 6 illustre en particulier un mode de mise en œuvre, dans le cas du transistor 100, d'une configuration électrique du transistor 100 lors de la sous-étape 404-2 du procédé exposé en relation avec la figure 4.

Durant la sous-étape 404-2 (figure 4) :

le potentiel $V_S$ de source auquel est portée l'électrode de source 114S du transistor 100 est sensiblement nul ($V_S = 0$ V) ;
le potentiel $V_D$ de drain auquel est portée l'électrode de drain 114D du transistor 100 est sensiblement nul ($V_D = 0$ V) ; et
le potentiel $V_G$ de grille auquel est portée l'électrode de grille 114G du transistor 100 est non nul ($V_G \neq 0$ V), de préférence négatif.

L'électrode de source 114S et l'électrode de drain 114D du transistor 100 sont toutes les deux mises à la masse. Selon un mode de mise en œuvre, le potentiel de grille $V_G$ non nul est imposé, sur un plot 122G de grille, par une source de tension extérieure au transistor 100, par exemple par un appareil de mesure (non représenté).

La figure 7 est un chronogramme d'évolution, en fonction du temps t, de la valeur absolue du potentiel de grille $V_G$ auquel est portée l'électrode de grille 114G du transistor 100. En particulier, la figure 7 illustre partiellement un mode de mise en œuvre de l'étape 404 du procédé exposé en relation avec la figure 4.

À un instant t0, on applique sur l'électrode de grille 114G du transistor 100 un potentiel de grille $V_G$ égal, en valeur absolue, à une valeur notée $V_{GStress}$. L'électrode de source 114S étant mise à la masse, cela revient à appliquer, entre l'électrode de grille 114G et l'électrode de source 114S, une tension de polarisation $V_{GS}$ égale à $V_{GStress}$. Le potentiel de grille $V_G$ est maintenu sensiblement égal à la valeur $V_{GStress}$ jusqu'à un instant t1, postérieur à l'instant t0.

À l'instant t1, on applique sur l'électrode de grille 114G du transistor 100 un potentiel $V_G$ sensiblement nul. Puis, à partir de l'instant t1 et jusqu'à un instant t2 postérieur à l'instant t1, on effectue une mesure de la tension de seuil $V_{TH}$ du transistor 100. La mesure de la tension de seuil $V_{TH}$ est effectuée, comme illustré en figure 7, en appliquant par paliers, sur l'électrode de grille 114G du transistor 100, des valeurs croissantes de potentiel de grille $V_G$. Bien que cela ne soit pas représenté en figure 7, une mesure de courant de drain, noté $I_D$, est effectuée à chaque palier, donc à chaque nouvelle valeur du potentiel $V_G$.

Les opérations effectuées entre les instants t0 et t1, respectivement entre les instants t1 et t2, correspondent à la sous-étape 404-2, respectivement à la sous-étape 404-4, du mode de mise en œuvre du procédé exposé en relation avec la figure 4.

En supposant que la durée totale TD ne soit pas écoulée à l'instant t2, un nouveau cycle d'application du potentiel $V_{GStress}$ et de mesure de la tension de seuil $V_{TH}$ débute alors à l'instant t2. Plusieurs cycles de ce type peuvent ainsi s'enchaîner entre l'instant t2 et un instant t3, postérieur à l'instant t2, où débute une ultime mesure 404-4 de la tension de seuil $V_{TH}$ du transistor 100.

Cette ultime mesure 404-4 de la tension de seuil $V_{TH}$ du transistor 100 s'achève à un instant t4, postérieur à l'instant t3. En supposant que la durée TD se soit écoulée entre les instants t3 et t4, l'électrode de grille 114G du transistor 100 est portée à un potentiel $V_G$ nul à partir de l'instant t4. À l'instant t4, on peut alors passer à la sous-étape 404-6 du procédé exposé en relation avec la figure 4.

La figure 8 est un graphique de variation d'un courant de drain en fonction d'un potentiel de grille. En particulier, la figure 8 illustre un exemple de courbe 800 d'évolution, pendant la sous-étape 404-4 de mesure de la tension de seuil $V_{TH}$, du courant de drain $I_D$ du transistor 100 en fonction du potentiel de grille $V_G$.

Comme illustré en figure 8, la courbe 800 d'évolution du courant de drain $I_D$ en fonction du potentiel de grille $V_G$ du transistor 100 présente :

une portion 800-1 (à gauche, en figure 8) où le courant de drain $I_D$ est sensiblement nul ; et
une autre portion 800-2 (à droite, en figure 8) où le courant de drain $I_D$ augmente progressivement depuis une valeur environ égale à zéro jusqu'à une valeur maximale, notée $I_{Dmax}$.

La valeur de potentiel $V_G$ pour laquelle le courant de drain $I_D$ commence à augmenter de manière notable, autrement dit la valeur de potentiel $V_G$ pour laquelle on passe de la portion 800-1 de la courbe 800 à la portion 800-2 de la courbe 800, est environ égale à la tension de seuil $V_{TH}$ du transistor 100. La mesure du courant de drain $I_D$ du transistor 100 en fonction du potentiel de grille $V_G$ est ainsi une façon d'accéder à la tension de seuil $V_{TH}$ du transistor 100.

La figure 9 est un graphique de variation d'une capacité en fonction d'un potentiel de grille. En particulier, la figure 9 illustre un exemple de courbe 900 d'évolution, pendant la sous-étape 404-4 (figure 4) de mesure de la tension de seuil $V_{TH}$, d'une capacité C de grille du transistor 100 en fonction du potentiel de grille $V_G$.

Comme illustré en figure 9, la courbe 900 d'évolution de la capacité de grille C en fonction du potentiel de grille $V_G$ du transistor 100 présente :

une portion 900-1 (à gauche, en figure 9) où la capacité C augmente depuis une valeur minimale, notée $C_{MIN}$, jusqu'à une valeur intermédiaire, notée $C_{INT}$ ; et
une autre portion 900-2 (à droite, en figure 9) où la capacité C augmente depuis la valeur $C_{INT}$ jusqu'à une valeur maximale, notée $C_{MAX}$.

En figure 9, la courbe 900 présente un point d'inflexion 900-3 marquant une séparation entre la portion 900-1 et la portion 900-2. La valeur de potentiel $V_G$ correspondant au point d'inflexion 900-3 de la courbe 900, autrement dit la valeur de potentiel $V_G$ pour laquelle on passe de la portion 900-1 de la courbe 900 à la portion 900-2 de la courbe 900, est environ égale à la tension de seuil $V_{TH}$ du transistor 100. La mesure de la capacité C du transistor 100 en fonction du potentiel de grille $V_G$ est ainsi une autre façon d'accéder à la tension de seuil $V_{TH}$ du transistor 100.

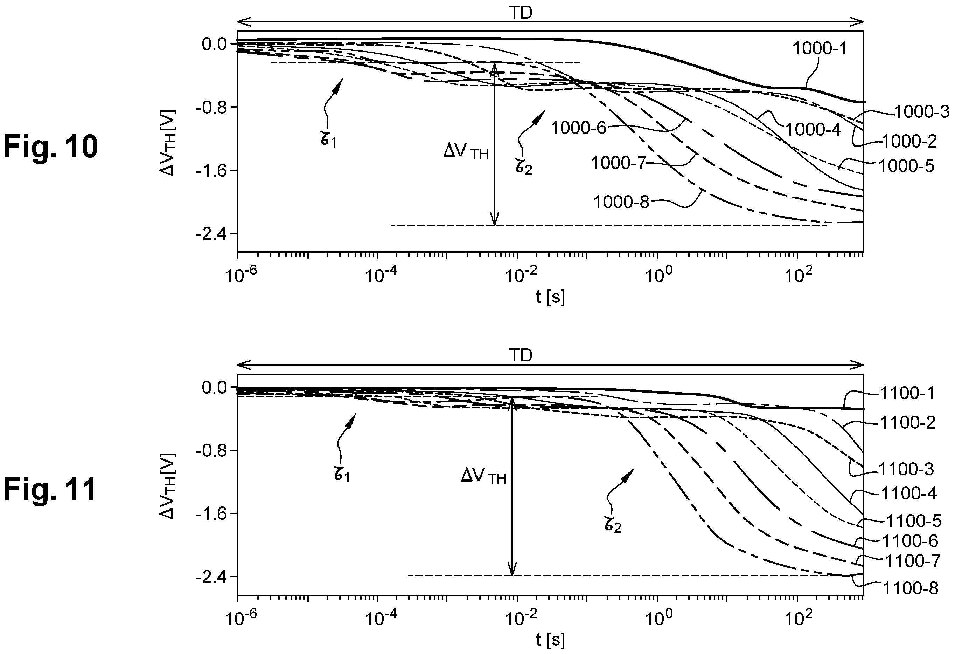

La figure 10 est un graphique d'évolution, en fonction du temps et pour différentes températures, d'un décalage d'une tension de seuil d'un composant électronique. En particulier, la figure 10 illustre des exemples de courbes 1000-1, 1000-2, 1000-3, 1000-4, 1000-5, 1000-6, 1000-7 et 1000-8 d'évolution, en fonction du temps t (en secondes), du décalage $\Delta V_{TH}$ (en volts) de la tension de seuil $V_{TH}$ du transistor 100. Dans l'exemple de la figure 10, le transistor 100 présente une longueur de grille $L_G$ (figure 1) de 0,25 $\mu$m et une largeur de grille de 200 $\mu$m. Les courbes 1000-1 à 1000-8 sont obtenues en appliquant un potentiel $V_{GStress}$ (figure 7) d'environ -5 V.

Les courbes 1000-1 à 1000-8 de la figure 10 sont, par exemple, issues de la réalisation de l'étape 404 du procédé exposé en relation avec la figure 4 pour différentes températures de chauffage du transistor 100. Plus précisément, dans l'exemple de la figure 10, les courbes 1000-1 à 1000-8 correspondent à un chauffage du transistor 100, pendant l'étape 404, à des températures respectivement égales à vingt-cinq degrés Celsius (25 °C), soixante-quinze degrés Celsius (75 °C), cent degrés Celsius (100 °C), cent vingt-cinq degrés Celsius (125 °C), cent cinquante degrés Celsius (150 °C), cent soixante-quinze degrés Celsius (175 °C), deux cents degrés Celsius (200 °C) et deux cent vingt-cinq degrés Celsius (225 °C).

Les courbes 1000-1 à 1000-8 de la figure 10 présentent chacune deux constantes de temps, notées $\tau_1$ et $\tau_2$, respectivement associées à deux plateaux. La courbe 1000-8 présente notamment un plateau compris entre environ cent microsecondes ($10^{-4}$ s) et dix millisecondes ($10^{-2}$ s), auquel est associée la constante de temps $\tau_1$, et un autre plateau débutant aux alentours de cent secondes ($10^2$ s), auquel est associée la constante de temps $\tau_2$. La différence entre ces deux plateaux permet, comme illustré en figure 10, d'évaluer la valeur du décalage $\Delta V_{TH}$.

En figure 10, on constate que plus la température de chauffage du transistor 100 pendant l'étape 404 est élevée, plus la valeur du décalage $\Delta V_{TH}$ est importante.

La figure 11 est un graphique d'évolution, en fonction du temps et pour différentes températures, d'un décalage d'une tension de seuil d'un autre composant électronique. En particulier, la figure 11 illustre des exemples de courbes 1100-1, 1100-2, 1100-3, 1100-4, 1100-5, 1100-6, 1100-7 et 1100-8 d'évolution, en fonction du temps t (en secondes), du décalage $\Delta V_{TH}$ (en volts) de la tension de seuil $V_{TH}$ du transistor 100.

Les courbes 1100-1 à 1100-8 de la figure 11 sont obtenues dans des conditions similaires à celles des courbes 1000-1 à 1000-8 de la figure 10, respectivement, à l'exception du fait que, en figure 11, le transistor 100 possède une longueur de grille égale à 20 $\mu$m.

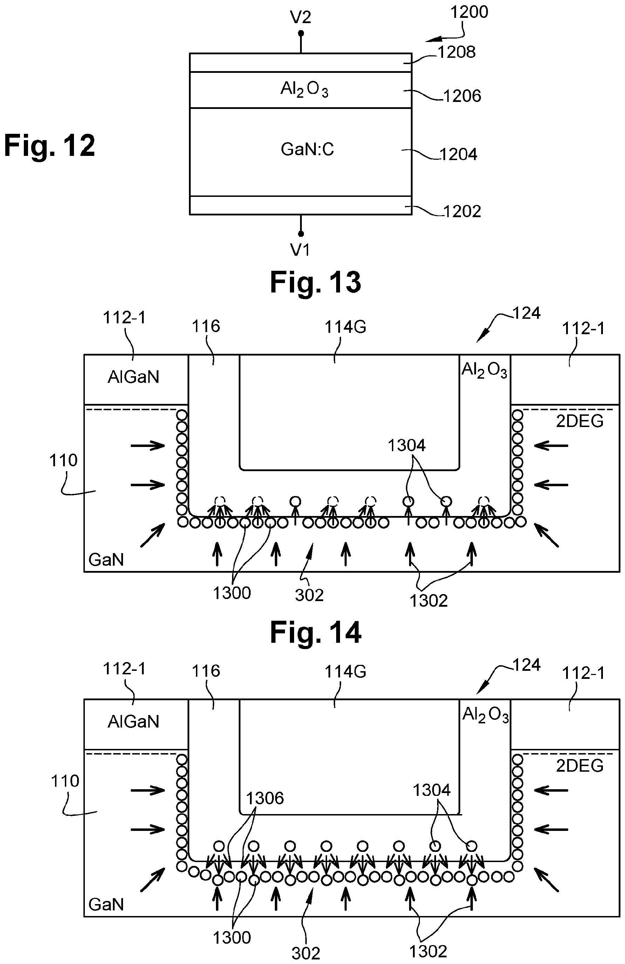

La figure 12 est une vue en coupe simplifiée, schématique et partielle, d'un exemple de condensateur 1200.

Dans l'exemple de la figure 12, le condensateur 1200 est un condensateur métal-oxyde-semiconducteur (metal-oxide-semiconductor - MOS). Le condensateur 1200 comporte :

    une électrode 1202 portée à un potentiel V1 ;
    une couche 1204 (GaN:C) en nitrure de gallium dopé au carbone, située sur et en contact avec l'électrode 1202 ;
    une couche 1206 ($Al_2O_3$) en alumine, située sur et en contact avec la couche 1204 ; et
    une autre électrode 1208, située sur et en contact avec la couche 1206, et portée à un potentiel V2.

La couche 1204 et la couche 1206 du condensateur 1200 sont respectivement semblables aux couches 106 et 116 du transistor 100 de la figure 1.

Le mode de mise en œuvre du procédé exposé ci-dessus en relation avec la figure 4 peut être adapté à l'évaluation d'une concentration de carbone en site azote dans la couche 1204 en GaN:C du condensateur MOS 1200. Le cas échéant, le potentiel V1 est, par exemple, sensiblement nul tandis que le potentiel V2 est, par exemple, analogue au potentiel $V_G$ exposé ci-dessus en relation avec la figure 7. La tension de seuil $V_{TH}$ correspond, dans le cas du condensateur MOS 1200, à une tension limite entre un régime d'inversion et un régime de déplétion du condensateur MOS 1200.

L'adaptation du mode de mise en œuvre du procédé exposé ci-dessus en relation avec la figure 4 au cas du condensateur MOS 1200 est à la portée de l'homme du métier à partir des indications ci-dessus.

La figure 13 est une vue en coupe simplifiée, schématique et partielle, de la portion 124 de la figure 2 du transistor 100 de la figure 1 dans encore un autre mode de fonctionnement.

La figure 13 illustre en particulier une situation dans laquelle un potentiel de grille $V_G$ supérieur à la tension de seuil $V_{TH}$ commence à être appliqué au transistor 100. Dans cette situation, des charges 1300 faisant partie du canal d'électrons 302 formé entre les deux parties du gaz d'électrons bidimensionnel 2DEG sont soumises à un champ électrique (symbolisé par des flèches 1302) dirigé vers l'électrode de grille 114G. Cela entraîne le piégeage, dans la couche 116 d'oxyde de grille, de charges 1304 issues du canal d'électrons 302. Le mode de fonctionnement illustré en figure 13 est appelé « régime d'accumulation », du fait que des charges, ici des électrons, sont accumulées dans la couche d'oxyde de grille 116.

La figure 14 est une vue en coupe simplifiée, schématique et partielle, de la portion 124 de la figure 2 du transistor 100 de la figure 1 dans encore un autre mode de fonctionnement.

La figure 14 illustre en particulier une situation dans laquelle un potentiel de grille $V_G$ supérieur à la tension de seuil $V_{TH}$ a été appliqué pendant plusieurs secondes au transistor 100. Dans cette situation, les charges 1304 piégées dans la couche d'oxyde de grille 116 produisent chacune un champ électrique (symbolisé par des flèches 1306). Le champ électrique 1306 produit par chaque charge 1304 tend à s'opposer au champ électrique 1302 des charges 1300 du canal d'électrons 302.

La présence des charges 1304 dans la couche 116 est à l'origine d'un phénomène appelé instabilité de polarisation en température (Bias Temperature Instability - BTI). Ce phénomène entraîne notamment une dégradation progressive de performances électriques du transistor 100. Ce phénomène semble, en particulier, être responsable du décalage $\Delta V_{TH}$ de la tension de seuil $V_{TH}$ du transistor 100.

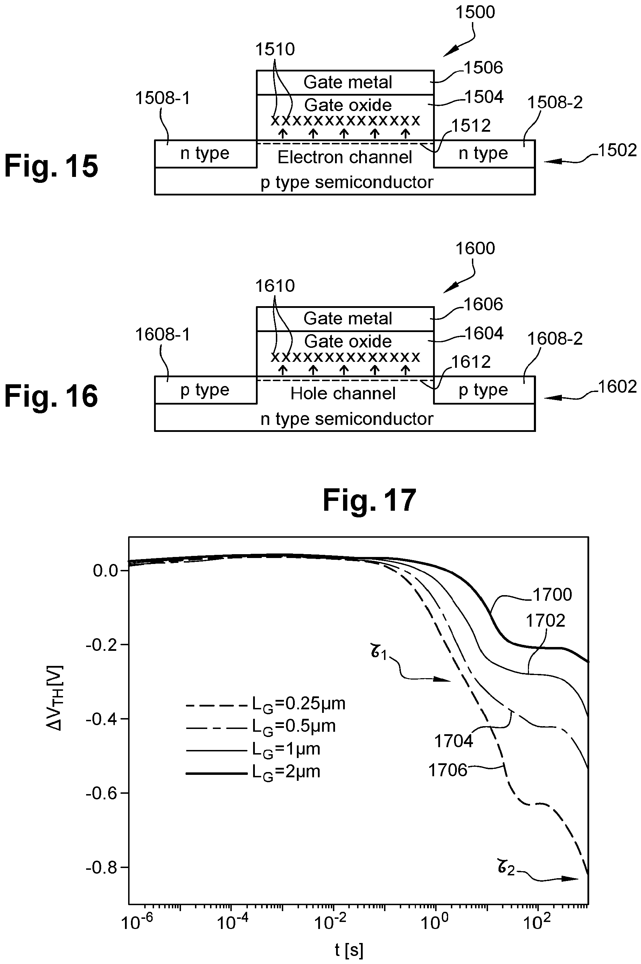

La figure 15 est une vue schématique et partielle d'un transistor 1500 dans un mode de fonctionnement.

Le transistor 1500 est un transistor MOS à canal n (nMOS) comportant :

    une couche 1502 (p type semiconductor) en matériau semiconducteur dopé de type p ;
    une couche 1504 (Gate oxide) d'oxyde de grille, située sur et en contact avec une partie de la couche 1502 ;
    une couche 1506 (Gate metal) de métal de grille, située sur et en contact avec la couche 1504 d'oxyde de grille ; et

deux régions 1508-1 (n type) et 1508-2 (n type) en matériau semiconducteur dopé de type n, formées dans la couche 1502 de part et d'autre de la couche 1504 d'oxyde de grille.

On suppose que les régions 1508-1 et 1508-2 sont respectivement connectées à la source et au drain du transistor 1500. On suppose en outre que :

la source du transistor 1500 est portée à un potentiel nul, par exemple la masse ;
le drain du transistor 1500 est porté à un potentiel strictement positif ; et
la grille du transistor 1500 est portée à un potentiel positif supérieur à la tension de seuil du transistor 1500.

Cela entraîne un piégeage de charges 1510 (ici, des électrons) dans la couche 1504 d'oxyde de grille. Les charges 1510 piégées dans la couche 1504 sont, en figure 15, symbolisées par des croix (x). Les charges 1510 proviennent d'un canal d'électrons 1512 (Electron channel) formé dans la couche 1502 entre les régions 1508-1 et 1508-2, et à l'interface entre la couche 1502 et la couche 1504.

Le piégeage des électrons 1510 dans la couche 1504 est à l'origine d'un décalage $\Delta V_{TH}$ positif de la tension de seuil $V_{TH}$, appelé instabilité positive de polarisation en température (positive Bias Temperature Instability - pBTI).

La figure 16 est une vue schématique et partielle d'un autre transistor 1600 dans un autre mode de fonctionnement.

Le transistor 1600 est un transistor MOS à canal p (pMOS) comportant :

une couche 1602 (n type semiconductor) en matériau semiconducteur dopé de type n ;
une couche 1604 (Gate oxide) d'oxyde de grille, située sur et en contact avec une partie de la couche 1602 ;
une couche 1606 (Gate metal) de métal de grille, située sur et en contact avec la couche 1604 d'oxyde de grille ; et
deux régions 1608-1 (p type) et 1608-2 (p type) en matériau semiconducteur dopé de type p, formées dans la couche 1602 de part et d'autre de la couche 1604 d'oxyde de grille.

On suppose que les régions 1608-1 et 1608-2 sont respectivement connectées à la source et au drain du transistor 1600. On suppose en outre que :

la source du transistor 1600 est portée à un potentiel nul, par exemple la masse ;
le drain du transistor 1600 est porté à un potentiel strictement négatif ; et
la grille du transistor 1600 est portée à un potentiel négatif inférieur à la tension de seuil du transistor 1600.

Cela entraîne un piégeage de charges 1610 (ici, des trous) dans la couche 1604 d'oxyde de grille. Les charges 1610 piégées dans la couche 1604 sont, en figure 16, symbolisées par des croix (x). Les charges 1610 proviennent d'un canal de trous 1612 (Hole channel) formé dans la couche 1602 entre les régions 1608-1 et 1608-2, et à l'interface entre la couche 1602 et la couche 1604.

Le piégeage des trous 1610 dans la couche 1604 est à l'origine d'un décalage $\Delta V_{TH}$ négatif de la tension de seuil $V_{TH}$, appelé instabilité négative de polarisation en température (negative Bias Temperature Instability - nBTI).

Le transistor 100 exposé en relation avec la figure 1 étant un transistor s'apparentant à un nMOS, c'est-à-dire ne présentant pas de trous, on ne s'attend pas à observer un décalage $\Delta V_{TH}$ négatif de la tension de seuil $V_{TH}$ du transistor 100 lorsqu'un potentiel $V_G$ négatif est appliqué sur sa grille. Toutefois, les inventeurs ont constaté que le fait de porter la grille du transistor 100 à un potentiel $V_G$ négatif entraînait progressivement, au fil du temps, un décalage $\Delta V_{TH}$ négatif.

La figure 17 est un graphique d'évolution, en fonction du temps t en secondes (s), d'un décalage $\Delta V_{TH}$ en volts (V) d'une tension de seuil $V_{TH}$ de composants électroniques, par exemple de transistors analogues au transistor 100 mais présentant des longueurs de grille $L_G$ différentes.

Le graphique de la figure 17 comporte en particulier :

une courbe 1700 d'évolution du décalage $\Delta V_{TH}$ de la tension de seuil $V_{TH}$ d'un transistor 100 dont la longueur de grille $L_G$ est égale à 2 $\mu$m ($L_G$=2$\mu$m) ;
une courbe 1702 d'évolution du décalage $\Delta V_{TH}$ de la tension de seuil $V_{TH}$ d'un transistor 100 dont la longueur de grille $L_G$ est égale à 1 $\mu$m ($L_G$=1$\mu$m) ;
une courbe 1704 d'évolution du décalage $\Delta V_{TH}$ de la tension de seuil $V_{TH}$ d'un transistor 100 dont la longueur de grille $L_G$ est égale à 0,5 $\mu$m ($L_G$=0.5$\mu$m) ; et
une courbe 1706 d'évolution du décalage $\Delta V_{TH}$ de la tension de seuil $V_{TH}$ d'un transistor 100 dont la longueur de grille $L_G$ est égale à 0,25 $\mu$m ($L_G$=0.25$\mu$m).

Les courbes 1700, 1702, 1704 et 1706 de la figure 17 sont obtenues, par exemple, pour un potentiel $V_{GStress}$ de -5 V, une largeur de grille de 200 $\mu$m et une température de vingt-cinq degrés Celsius (25 °C). Comme illustré en figure 17, une diminution de la longueur de grille $L_G$ du transistor 100 tend à accentuer le décalage $\Delta V_{TH}$ de la tension de seuil $V_{TH}$. La figure 17 illustre en outre la présence, pour chaque courbe 1700, 1702, 1704 et 1706, des constantes de temps $\tau_1$ et $\tau_2$ précédemment décrites en relation avec la figure 10.

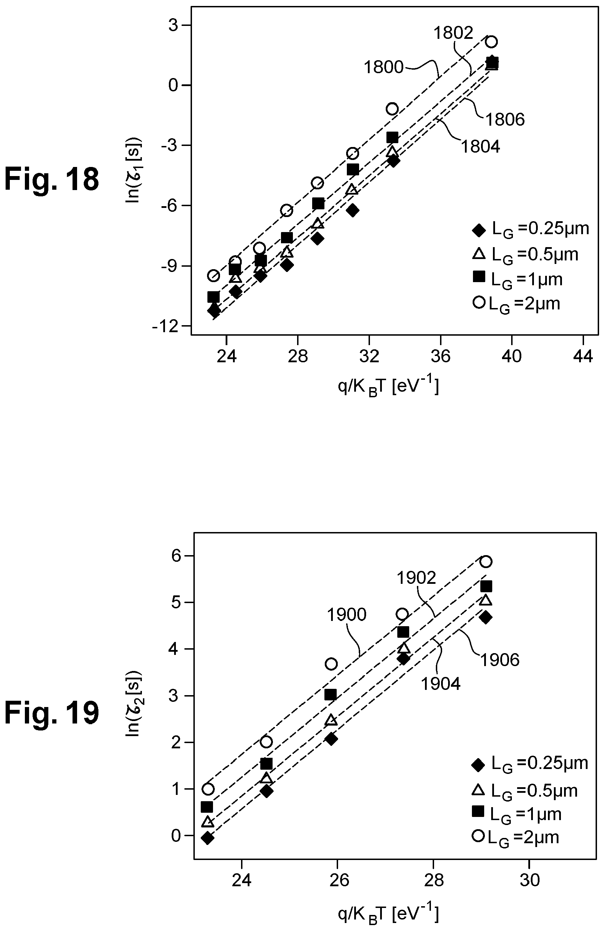

La figure 18 est un graphique d'Arrhenius associé à la constante de temps $\tau_1$. La figure 18 illustre en particulier, pour différentes longueurs de grille $L_G$, la variation du logarithme népérien de la constante de temps $\tau_1$ ($\ln(\tau_1)$) en fonction d'un quotient noté $q/K_B T$ (en $eV^{-1}$), où :

> q représente la charge élémentaire, approximativement égale à $1{,}6.10^{-19}$ C ;
> $K_B$ représente la constante de Boltzmann, approximativement égale à $8{,}6.10^{-5}$ $eV.K^{-1}$ ; et
> T représente la température absolue, exprimée en degrés Kelvin.

Le graphique de la figure 18 comporte en particulier :

> une courbe 1800 correspondant à un transistor 100 dont la longueur de grille $L_G$ est égale à 2 $\mu$m ($L_G$=2$\mu$m) ;
> une courbe 1802 correspondant à un transistor 100 dont la longueur de grille $L_G$ est égale à 1 $\mu$m ($L_G$=1$\mu$m) ;
> une courbe 1804 correspondant à un transistor 100 dont la longueur de grille $L_G$ est égale à 0,5 $\mu$m ($L_G$=0.5$\mu$m) ; et
> une courbe 1806 correspondant à un transistor 100 dont la longueur de grille $L_G$ est égale à 0,25 $\mu$m ($L_G$=0.25$\mu$m).

Les courbes 1800, 1802, 1804 et 1806 de la figure 18 sont obtenues, par exemple, pour un potentiel $V_{GStress}$ de -5 V et une largeur de grille de 200 $\mu$m. Les courbes 1800, 1802, 1804 et 1806 sont des droites présentant sensiblement une même pente, correspondant à une énergie d'activation égale à environ 0,8 eV.

La figure 19 est un graphique d'Arrhenius associé à la constante de temps $\tau_2$. La figure 19 illustre en particulier, pour différentes longueurs de grille $L_G$, la variation du logarithme népérien de la constante de temps $\tau_2$ ($\ln(\tau_2)$) en fonction du quotient $q/K_B T$ (en $eV^{-1}$) décrit ci-dessus en relation avec la figure 18.

Le graphique de la figure 19 comporte en particulier :

> une courbe 1900 correspondant à un transistor 100 dont la longueur de grille $L_G$ est égale à 2 $\mu$m ($L_G$=2$\mu$m) ;
> une courbe 1902 correspondant à un transistor 100 dont la longueur de grille $L_G$ est égale à 1 $\mu$m ($L_G$=1$\mu$m) ;
> une courbe 1904 correspondant à un transistor 100 dont la longueur de grille $L_G$ est égale à 0,5 $\mu$m ($L_G$=0.5$\mu$m) ; et
> une courbe 1906 correspondant à un transistor 100 dont la longueur de grille $L_G$ est égale à 0,25 $\mu$m ($L_G$=0.25$\mu$m).

Les courbes 1900, 1902, 1904 et 1906 de la figure 19 sont obtenues, par exemple, pour un potentiel $V_{GStress}$ de -5 V et une largeur de grille de 200 $\mu$m. Les courbes 1900, 1902, 1904 et 1906 sont des droites présentant sensiblement une même pente, correspondant à une énergie d'activation égale à environ 0,8 eV.

Partant de l'observation des figures 18 et 19, les inventeurs ont constaté que les énergies d'activation associées aux constantes de temps $\tau_1$ et $\tau_2$ étaient toutes deux sensiblement égales à 0,8 eV. On considère que cela correspond à une énergie d'ionisation des atomes de carbone en site azote dans une couche de nitrure de gallium.

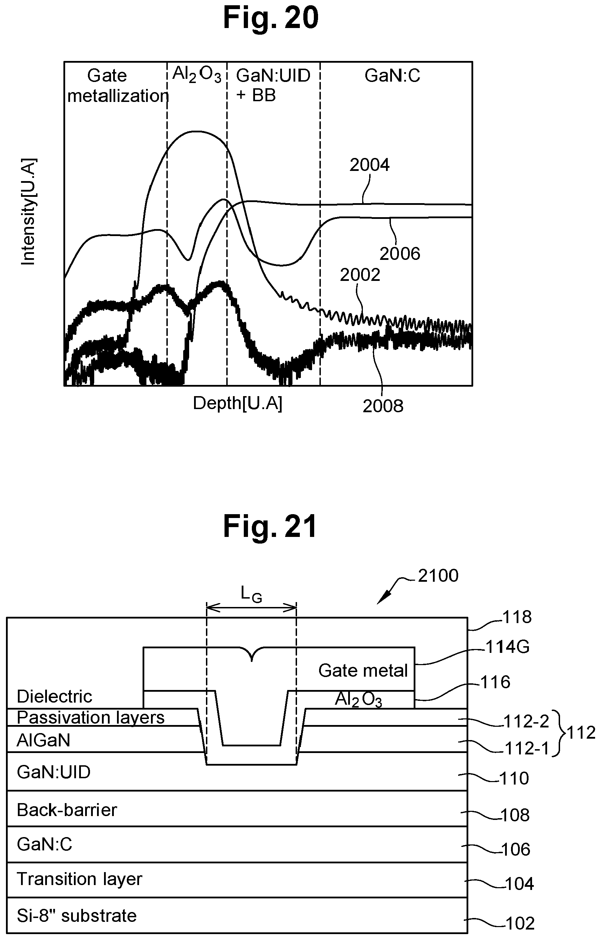

La figure 20 est un graphique de variation, en fonction d'une profondeur (Depth), en unités arbitraires, d'une concentration en espèces chimiques (Intensity), en unités arbitraires. La profondeur est, en figure 20, référencée par rapport à l'électrode de grille 114G (figure 1).

Le graphique de la figure 20 est, par exemple, obtenu par spectrométrie de masse des ions secondaires (Secondary Ion Mass Spectroscopy - SIMS) en surface supérieure de la portion 124 du transistor 100 (figure 1). La spectroscopie SIMS est, par exemple, effectuée après gravure humide (wet etching) de la couche 120 de TEOS par exposition pendant 30 min à une solution d'acide fluorhydrique (HF) concentrée à 10 %. Cela permet d'améliorer la résolution de la mesure.

Le graphique de la figure 20 comporte quatre zones de profondeur :

> une zone (Gate metallization) correspondant à l'épaisseur de l'électrode de grille 114G ;
> une autre zone ($Al_2O_3$) correspondant à la couche 116 d'oxyde de grille ;
> encore une autre zone (GaN:UID + BB) correspondant aux épaisseurs cumulées des couches 110 et 108 ; et
> encore une autre zone (GaN:C) correspondant à la couche 106.

En figure 20 :

> une courbe 2002 représente une variation de concentration en oxyde d'aluminium ;
> une autre courbe 2004 représente une variation de concentration en nitrure de gallium ;
> encore une autre courbe 2006 représente une variation de concentration en nitrure de carbone ; et
> encore une autre courbe 2008 représente une variation de concentration en carbone.

Comme illustré en figure 20, la courbe 2006 révèle une forte concentration en nitrure de carbone dans la couche 106 en nitrure de gallium dopé au carbone. La courbe 2006 révèle en outre une forte population en carbone au voisinage de l'interface entre la couche 116 et la couche 110.

La figure 21 est une vue en coupe, schématique et partielle, d'un transistor 2100 normalement bloqué (normally off) .

Le transistor 2100 possède, par exemple, une structure analogue à celle du transistor 100 comme exposé ci-dessus en relation avec la figure 1. Le transistor 2100 comporte en particulier :

le substrat 102 (Si-8" substrate) en silicium ;
la couche 104 (Transition layer) de transition ;
la couche 106 (GaN:C) en nitrure de gallium dopé au carbone ;
la couche barrière 108 (Back-barrier) ;
la couche 110 (GaN:UID) en nitrure de gallium involontairement dopé ;
la couche 112, comprenant la sous-couche 112-1 (AlGaN) en nitrure d'aluminium-gallium et la sous-couche 112-2 (Passivation layers) de passivation ;
la couche 116 (Al$_2$O$_3$) d'oxyde de grille ;
l'électrode de grille 114G (Gate metal) de métallisation de grille ; et
la couche 118 (Dielectric) à base de matériaux diélectriques.

Comme illustré en figure 21, la couche 116 présente une forme de « U ». La couche 116 traverse entièrement la couche 112 et pénètre à l'intérieur de la couche 110. L'électrode de grille 114G est située sur et en contact avec la couche 116. En d'autres termes, le transistor 2100 possède une grille « encastrée » (recessed) dans la couche 110 en GaN:UID.

Dans l'exemple de la figure 21, la longueur de grille L$_G$ correspond à la longueur de la partie inférieure du « U » formé par la couche 116.

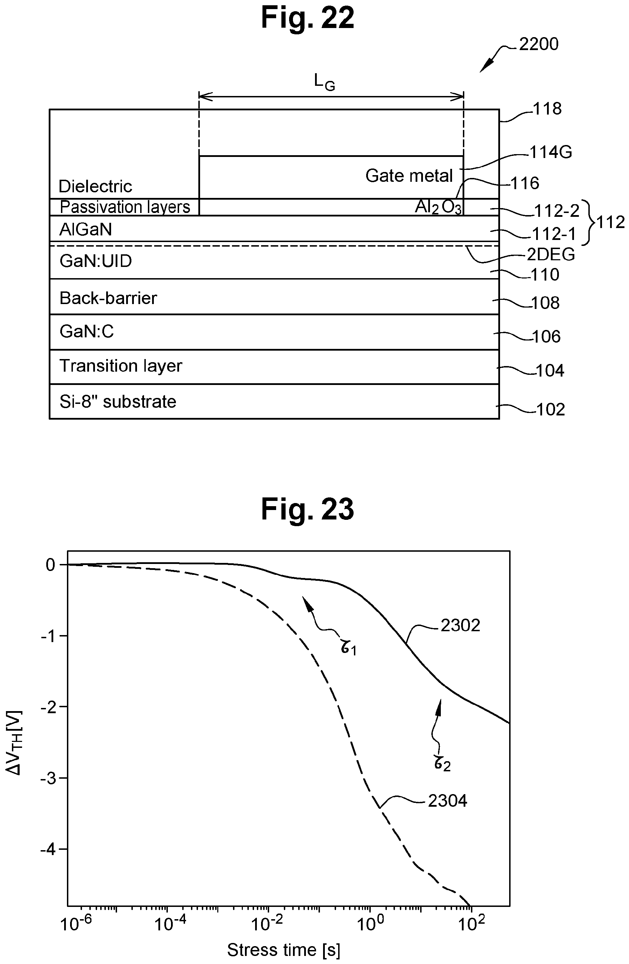

La figure 22 est une vue en coupe, schématique et partielle, d'un transistor 2200 normalement passant (normally on). Le transistor 2200 de la figure 22 comprend des éléments communs avec le transistor 2100 de la figure 21. Ces éléments communs ne seront pas détaillés à nouveau ci-après.

Le transistor 2200 de la figure 22 diffère du transistor 2100 de la figure 21 principalement en ce que le transistor 2200 possède une grille dite « non encastrée ». En particulier, la couche 116 (Al$_2$O$_3$) d'oxyde de grille ne traverse pas la couche 112 et ne pénètre pas à l'intérieur de la couche 110.

Comme illustré en figure 22 :

la couche 116 (Al$_2$O) d'oxyde de grille pénètre à l'intérieur de la sous-couche 112-2 de passivation ; et
l'électrode de grille 114G (Gate metal), située sur et en contact de la couche 116, est recouverte par la couche 118 (Dielectric).

Le gaz d'électrons bidimensionnel 2DEG est formé dans la couche 110 (GaN:UID), au voisinage de l'interface entre la couche 110 et la sous-couche 112-1 (AlGaN).

La figure 23 est un graphique d'évolution, en fonction du temps (Stress time), en secondes (s), d'un décalage $\Delta V_{TH}$ d'une tension de seuil, en volts (V), des transistors 2100 et 2200 des figures 21 et 22, respectivement.

Le graphique 23 comporte en particulier :

une courbe 2302 correspondant à l'évolution du décalage $\Delta V_{TH}$ de la tension de seuil du transistor 2100 normalement bloqué de la figure 21 ; et
une autre courbe 2304 correspondant à l'évolution du décalage $\Delta V_{TH}$ de la tension de seuil du transistor 2200 normalement passant de la figure 22.

Les transistors 2100 et 2200 possèdent une longueur de grille L$_G$ égale à 1 $\mu$m et une largeur de grille égale à 100 $\mu$m. Les courbes 2302 et 2304 sont obtenues en appliquant des tensions de polarisation, respectivement, de -5 V et de -10 Vet en chauffant les transistors 2100 et 2200 à une température de cent cinquante degrés Celsius (150 °C).

La courbe 2302 correspondant au transistor 2100 normalement bloqué présente deux paliers auxquels sont associées les constantes de temps $\tau_1$ et $\tau_2$ comme exposé ci-dessus en relation avec la figure 10. La courbe 2304 correspondant au transistor 2200 normalement passant ne présente qu'un seul palier auquel est associée une autre constante de temps. Le graphique de la figure 23 semble indiquer que la constante de temps $\tau_2$ correspond à la couche 106 de GaN:C.

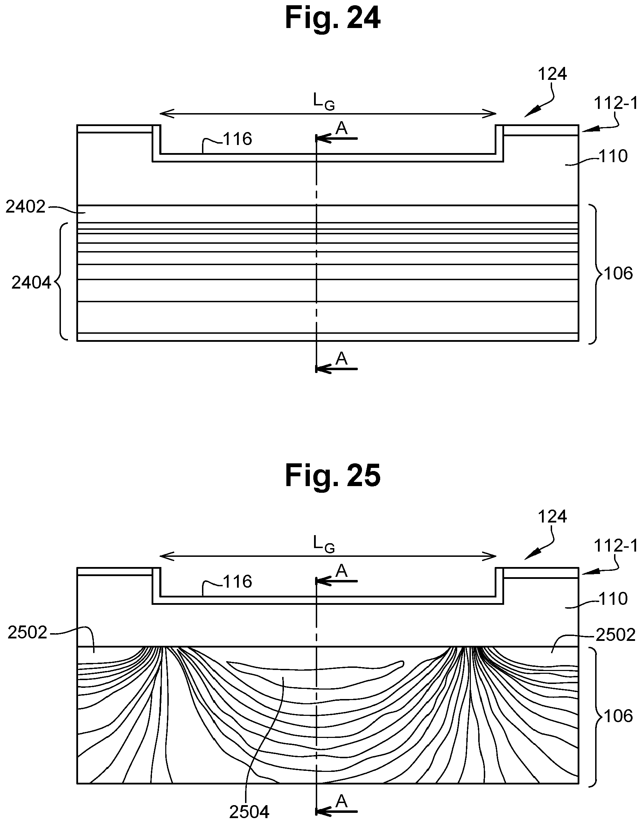

La figure 24 est une cartographie de pièges ionisés à l'intérieur de la portion 124 de la figure 2 du transistor 100 de la figure 1 dans un mode de fonctionnement. Les pièges correspondent ici à des atomes de carbone en site azote dans la couche 106 en GaN:C. On considère ici, pour simplifier, que la couche 108 est omise de l'empilement 124. Le transistor 100 possède une longueur de grille L$_G$ égale à 1 $\mu$m.

La figure 24 illustre plus précisément une situation antérieure à l'application du potentiel V$_{GStress}$ (figure 7) sur la grille du transistor 100. Dans cette situation, la majorité des pièges ionisés de la couche 106 sont situés sous la couche 116 d'oxyde de grille, dans une zone 2402 localisée à proximité de l'interface entre la couche 106 et la couche 110. Des zones 2404 distantes de l'interface entre la couche 106 et la couche 110, c'est-à-dire plus éloignées de cette interface que la zone 2402, présentent en revanche une plus faible concentration en pièges ionisés.

La figure 25 est une cartographie de pièges ionisés à l'intérieur de la portion 124 de la figure 2 du transistor 100 de la figure 1 dans un autre mode de fonctionnement. Les pièges correspondent ici encore à des atomes de carbone en site azote dans la couche 106 en GaN:C. On considère encore, pour simplifier, que la couche 108 est omise de l'empilement 124. Le transistor 100 possède une longueur de grille $L_G$ égale à 1 μm.

La figure 25 illustre plus précisément une situation 1 μs après l'application, pendant $10^3$ s, du potentiel $V_{GStress}$ (figure 7) sur la grille du transistor 100. Le potentiel $V_{GStress}$ est ici égal à -5 V. Dans cette situation, la majorité des pièges ionisés de la couche 106 est située de part et d'autre de la couche 116 d'oxyde de grille, dans des zones 2502 localisées à proximité de l'interface entre la couche 106 et la couche 110. Une zone 2504 située sous la couche 116 et à proximité de l'interface entre la couche 106 et la couche 110 présente, comme illustré en figure 25, une plus faible concentration en pièges ionisés. Cette plus faible concentration en pièges ionisés sous la couche 116 d'oxyde de grille du transistor 100 semble être responsable du décalage $\Delta V_{TH}$ de la tension de seuil du transistor 100.

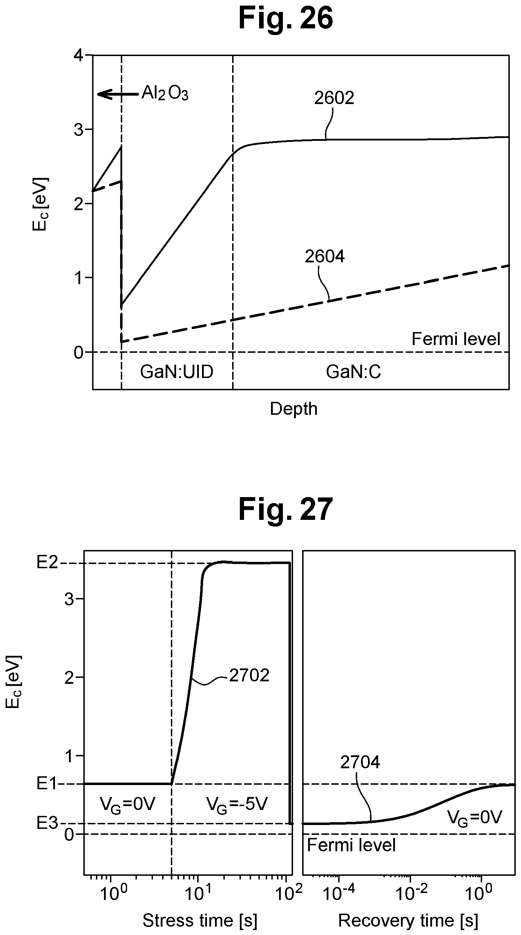

La figure 26 est un graphique de variation, en fonction d'une profondeur (Depth), d'une énergie ($E_C$) de bande de conduction, en électronvolts (eV), par rapport au niveau de Fermi (Fermi level). La figure 26 illustre, en particulier, l'évolution de l'énergie $E_C$ de bande de conduction :

le long d'une coupe AA dans le mode de fonctionnement de la figure 24 (courbe 2602) ; et
le long de la coupe AA dans le mode de fonctionnement de la figure 25 (courbe 2604).

Le graphique de la figure 26 comporte trois zones de profondeur :

une zone ($Al_2O_3$) correspondant à la couche 116 d'oxyde de grille ;
une autre zone (GaN:UID) correspondant à la couche 110 ; et
encore une autre zone (GaN:C) correspondant à la couche 106.

On constate comme illustré en figure 25 que l'application du potentiel $V_{GStress}$ (figure 7) sur la grille du transistor 100 tend à abaisser l'énergie $E_C$ de bande de conduction dans la couche 106 en GaN:C. Avant l'application du potentiel $V_{GStress}$, les pièges constitués par les atomes de carbone en site azote de la couche 106 sont ionisés et se comportent comme des charges négatives. Pendant l'application du potentiel négatif $V_{GStress}$, les électrons initialement capturés par les pièges ionisés sont repoussés sous l'effet du champ électrique. Cela a pour effet de neutraliser les pièges et provoque une diminution de la tension de seuil $V_{TH}$.

La figure 27 est un graphique d'évolution, en fonction du temps, en secondes (s), de l'énergie $E_C$ de bande de conduction, en électronvolts (eV), référencée par rapport au niveau de Fermi (Fermi level). L'énergie $E_C$ est, par exemple, mesurée à une profondeur d'environ 1 nm sous le milieu de la grille du transistor 100.

Le graphique de la figure 27 comporte une première période (Stress time, courbe 2702) pendant laquelle le potentiel de grille $V_G$ est d'abord nul (zone $V_G$=0V). L'énergie $E_C$ est alors égale à une valeur, notée E1. Toujours pendant la première période, le potentiel de grille $V_G$ est ensuite égal à -5 V (zone $V_G$=-5V). L'énergie $E_C$ augmente alors jusqu'à une autre valeur, notée E2, supérieure à la valeur E1. À la fin de la première période, le potentiel de grille $V_G$ est ramené à une valeur nulle. L'énergie $E_C$ décroît alors rapidement jusqu'à encore une autre valeur, notée E3, inférieure aux valeurs E1 et E2.

Pendant une deuxième période (Recovery time, courbe 2704), postérieure à la première période, le potentiel de grille $V_G$ est maintenu à une valeur nulle ($V_G$=0V). L'énergie $E_C$ augmente alors lentement depuis la valeur E3 pour atteindre, au bout d'environ 10 s, la valeur initiale E1.

Les courbes 2702 et 2704 sont comparables à une variation dynamique de la tension de seuil $V_{TH}$ du transistor 100. En figure 26, on constate en particulier que le décalage $\Delta V_{TH}$ de la tension de seuil $V_{TH}$ du transistor 100 s'annule au bout d'une durée environ égale à 10 s après application du potentiel de grille $V_G$.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, l'application du mode de mise en œuvre du procédé décrit en relation avec la figure 4 au cas du condensateur MOS 1200 (figure 12) est à la portée de l'homme du métier à partir des indications ci-dessus.

Enfin, la mise en œuvre pratique des modes de réalisation et variantes décrits est à la portée de l'homme du métier à partir des indications fonctionnelles données ci-dessus.

**Revendications**

1. Procédé d'évaluation d'une concentration de carbone en site azote, dans une première couche (106 ; 1204) épitaxiée en nitrure de gallium dopé au carbone d'un composant électronique (100 ; 1200), comprenant des étapes consistant à :

estimer une capacité électrique ($C_{eq}$) d'un empilement intercalé entre la première couche (106) et une première électrode (114G ; 1208) du composant ;
chauffer le composant ;
mesurer un décalage ($\Delta V_{TH}$) d'une tension de seuil ($V_{TH}$) du composant ; et
en déduire une concentration surfacique ($N_S$) de carbone en site azote dans la première couche.

2. Procédé selon la revendication 1, comprenant en outre une étape consistant à calculer, à partir de la concentration surfacique ($N_S$) et d'une épaisseur partielle ($t_{eff}$) de la première couche (106 ; 1204), une concentration volumique ($N_V$) de carbone en site azote dans la première couche.

**3.** Procédé selon la revendication 1 ou 2, dans lequel le chauffage du composant (100 ; 1200) est effectué à une température comprise entre cent et deux cent cinquante degrés Celsius, de préférence entre cent cinquante et deux cent cinquante degrés Celsius.

**4.** Procédé selon l'une quelconque des revendications 1 à 3, dans lequel l'empilement forme, avec la première électrode (114G), une structure de type MOS comprenant :

une deuxième couche (110) en nitrure de gallium, située sur la première couche (106) ; et une troisième couche (116) en alumine, pénétrant à l'intérieur de la deuxième couche, la première électrode (114G) étant située sur et en contact avec la troisième couche.

**5.** Procédé selon la revendication 4, dans lequel la capacité ($C_{eq}$) est estimée en fonction d'épaisseurs et de permittivités diélectriques respectives de la deuxième couche (110) et de la troisième couche (116).

**6.** Procédé selon l'une quelconque des revendications 1 à 5, dans lequel la première couche (106) est située sur un substrat (102), de préférence une plaquette de silicium orienté {111}.

**7.** Procédé selon l'une quelconque des revendications 1 à 6, dans lequel le décalage ($\Delta V_{TH}$) de la tension de seuil ($V_{TH}$) du composant (100 ; 1200) est déterminé à l'issue d'une étape (404) d'application, entre la première électrode (114G ; 1208) et une deuxième électrode (114S ; 1202) du composant, d'une tension de polarisation ($V_{GS}$) négative.

**8.** Procédé selon la revendication 7, dans lequel la tension de polarisation ($V_{GS}$) est inférieure à -1 V, de préférence environ égale à -5 V.

**9.** Procédé selon la revendication 7 ou 8, dans lequel l'étape (404) d'application de la tension de polarisation ($V_{GS}$) dure entre une et dix mille secondes, de préférence entre cent et dix mille secondes.

**10.** Procédé selon l'une quelconque des revendications 7 à 9, dans lequel l'étape (404) d'application de la tension de polarisation ($V_{GS}$) est interrompue, pendant dix à cent microsecondes, à plusieurs reprises pour évaluer la tension de seuil ($V_{TH}$) du composant (100 ; 1200) .

**11.** Procédé selon la revendication 10, dans lequel la tension de seuil ($V_{TH}$) du composant (100 ; 1200) est évaluée à partir d'une mesure de variation de capacité (C), entre la première électrode (114G ; 1208) et la deuxième électrode (114S ; 1202), en fonction d'une variation de potentiel ($V_G$) appliqué sur la première électrode (114G ; 1208).

**12.** Procédé selon la revendication 10, dans lequel la tension de seuil ($V_{TH}$) du composant (100) est évaluée à partir d'une mesure de variation d'un courant électrique ($I_D$) traversant le composant, en fonction d'une variation de potentiel ($V_G$) appliqué sur la première électrode (114G).

**13.** Procédé selon l'une quelconque des revendications 7 à 12 et selon la revendication 6, dans lequel le composant (100) est un transistor, de préférence un transistor à haute mobilité électronique, la première électrode (114G) étant une électrode de grille et la deuxième électrode (114S) étant une électrode connectée au substrat.

**14.** Procédé selon l'une quelconque des revendications 1 à 11, dans lequel le composant (1200) est un condensateur MOS.

**15.** Procédé selon l'une quelconque des revendications 1 à 14, dans lequel des paramètres d'épitaxie de la première couche (106 ; 1204) sont adaptés en fonction de l'évaluation de la concentration de carbone en site azote.

# Fig. 1

EP 3 828 920 A1

# Fig. 2

GATE
124
114G-2

114G 114G-1
118 116
112-2
112 112-1
114S 114D
SOURCE DRAIN
2DEG
2DEG
110
108
106

# Fig. 3

GATE
124
114G-2

114G 114G-1
118 116
112-2
112 112-1
114S 114D
SOURCE DRAIN
2DEG
2DEG
302
110
108
106

# Fig. 4

Estimate stack capacitance — 402

Evaluate $V_{TH}$ instability, $\Delta V_{TH}$

Heat device — 404-1

Apply gate stress bias — 404-2

no | Remove gate stress bias — 404-3

Measure $V_{TH}$ — 404-4

Timing over? — 404-5     404

yes

Plot $V_{TH}(t)$ — 404-6

Infer $\Delta V_{TH}$ — 404-7

Calculate $N_S$ — 406

## Fig. 5

114G

116 → Al$_2$O$_3$

110 → GaN:UID

N$_s$ - - - - - - - - - - - - - - - - - - - - - - - - - - - - - - - - - - - - - - - -

106 → GaN:C

C$_{Al2O3}$

C$_{GaNUID}$

C$_{eq}$

## Fig. 6

V$_S$ = 0 V ⌐122S

V$_G$ ≠ 0 V ⌐122G

V$_D$ = 0 V ⌐122D

100

114G

116

114S

114D

SOURCE

GATE

DRAIN

2DEG

## Fig. 7

V$_G$   404-2   404-4   404-2   404-4

V$_{GStress}$

t0   t1   t2   t3   t4   t

TD

Fig. 8

Fig. 9

Fig. 10

Fig. 11

V2

1200
1208
Al$_2$O$_3$
1206
GaN:C
1204
1202

V1

Fig. 12

Fig. 13

112-1     116     114G     124     112-1

AlGaN     Al$_2$O$_3$

2DEG

110

1304

GaN

1300     302     1302

Fig. 14

112-1     116     114G     124     112-1

AlGaN     Al$_2$O$_3$

2DEG

110

1306     1304

GaN

1300     302     1302

Fig. 15

Fig. 16

Fig. 17

**Fig. 18**

**Fig. 19**

# Fig. 20

# Fig. 21

# Fig. 22

# Fig. 23

# Fig. 24

# Fig. 25

# Fig. 26

# Fig. 27

Europäisches
Patentamt

European
Patent Office

Office européen
des brevets

**RAPPORT DE RECHERCHE EUROPEENNE**

Numéro de la demande

EP 20 20 4097

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2018/123285 A1 (SCIOCS CO LTD) 5 juillet 2018 (2018-07-05) * alinéas [0012], [0014], [0095], [0096]; figure 2a * & US 2020/091016 A1 (HORIKIRI FUMIMASA [JP] ET AL) 19 mars 2020 (2020-03-19) * alinéas [0030], [0032], [0113], [0114]; figure 2a * | 1-15 | INV. H01L21/66 G01R31/26 |
| A | FANG Z-Q ET AL: "Deep traps in AlGaN/GaN heterostructures studied by deep level transient spectroscopy: Effect of carbon concentration in GaN buffer layers", JOURNAL OF APPLIED PHYSICS, AMERICAN INSTITUTE OF PHYSICS, US, vol. 108, no. 6, 17 septembre 2010 (2010-09-17), pages 63706-63706, XP012142917, ISSN: 0021-8979, DOI: 10.1063/1.3488610 * le document en entier * | 1-15 | |
| A | JP 3 062975 B2 (NIPPON MINING CO) 12 juillet 2000 (2000-07-12) * alinéas [0008] - [0012]; revendication 1 * | 1-15 | DOMAINES TECHNIQUES RECHERCHES (IPC) H01L G01R |
| A | JP 2019 137566 A (SHINETSU HANDOTAI KK) 22 août 2019 (2019-08-22) * alinéas [0001] - [0005] * | 1-15 | |

Le présent rapport a été établi pour toutes les revendications

| Lieu de la recherche | Date d'achèvement de la recherche | Examinateur |
|---|---|---|
| Munich | 17 mars 2021 | Ronnås, Katharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 20 20 4097

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-03-2021

| Document brevet cité au rapport de recherche | | | Date de publication | Membre(s) de la famille de brevet(s) | | | Date de publication |
|---|---|---|---|---|---|---|---|
| WO 2018123285 | A1 | | 05-07-2018 | CN | 110191979 | A | 30-08-2019 |
| | | | | JP | WO2018123285 | A1 | 31-10-2019 |
| | | | | US | 2020091016 | A1 | 19-03-2020 |
| | | | | WO | 2018123285 | A1 | 05-07-2018 |
| JP 3062975 | B2 | | 12-07-2000 | JP | 3062975 | B2 | 12-07-2000 |
| | | | | JP | H05160159 | A | 25-06-1993 |
| JP 2019137566 | A | | 22-08-2019 | JP | 6838713 | B2 | 03-03-2021 |
| | | | | JP | 2019137566 | A | 22-08-2019 |

EPO FORM P0460

Pour tout renseignement concernant cette annexe : voir Journal Officiel de l'Office européen des brevets, No.12/82